# EUROPEAN PATENT APPLICATION

(11) **EP 4 628 990 A1**
(43) Date of publication of application: **08.10.2025**
(21) Application number: 24747232.7
(22) Date of filing: 22.01.2024
(51) Int. Cl.: G03F 7/40, C08F 220/30, C08G 59/40, C08G 65/331, G03F 7/004, H01L 21/027

(54) **ORGANIC RESIN COMPOSITION FOR FORMING METAL OXIDE RESIST PATTERN**

(30) Priority: 23.01.2023 JP 2023008017
(71) Applicant: Nissan Chemical Corporation, Tokyo 103-6119 (JP)
(72) Inventor: TAKEDA, Satoshi, Toyama-shi, Toyama 939-2792 (JP); SAKAMOTO, Rikimaru, Toyama-shi, Toyama 939-2792 (JP)
(74) Representative: Müller-Boré & Partner Patentanwälte PartG mbB
(86) International application number: PCT/JP2024/001555
(87) International publication number: WO 2024/157904

(57) **Abstract**

An organic film-forming composition, which is used for forming an organic film that is formed between resist patterns formed from a metal-containing resist film and that is then removed, the organic film-forming composition containing: an organic film constituent component; and a solvent.

## Description

### Technical Field

The present invention relates to an organic film-forming composition used for forming an organic film that is formed between resist patterns formed from a metal-containing resist and that is then removed.

### Background Art

Conventionally, microfabrication by lithography using a photoresist has been performed in the production of a semiconductor device. The microfabrication is a processing method of forming microrelief corresponding to a pattern on a substrate surface by forming a thin film of a photoresist on a semiconductor substrate such as a silicon wafer, irradiating the thin film with an active ray such as an ultraviolet ray through a mask pattern on which a semiconductor device pattern is drawn, developing the thin film, and etching the substrate using the obtained photoresist pattern as a protective film.

While the degree of integration of semiconductor devices has been increased, the wavelength of an active ray to be used also tends to be shortened from a KrF excimer laser (248 nm) to an ArF excimer laser (193 nm), and furthermore, an exposure technique using extreme ultraviolet (EUV) or an electron beam has been studied.

In order to achieve further fine patterning of the resist, development of lithography technology using a metal oxide resist (MOR, also referred to as metal-containing resist) having excellent etching resistance as compared with a conventional chemically amplified resist has been actively conducted in recent years (for example, Patent Literature 1 or the like). For further miniaturization in the future, it is essential to reduce the film thickness of the resist film, but this metal oxide resist (MOR) (hereinafter also referred to as a "metal-containing resist") has sufficient etching resistance to perform fine patterning even on a thin film, and thus is expected in recent years as a material to be used for next-generation EUV lithography technology.

### Citation List

### Patent Literature

Patent Literature 1: JP 2011-253185 A

### Summary of Invention

### Technical Problem

As the resist pattern formed from the metal-containing resist becomes finer, resist pattern collapse becomes a problem.

The present invention has been made in view of the above circumstances, and an object of the present invention is to provide an organic film-forming composition capable of preventing pattern collapse in fine patterning with a metal-containing resist film, and a method for producing a semiconductor element using the organic film-forming composition.

### Solution to Problem

As a result of intensive studies to solve the above problem, the present inventors have found that the above problem can be solved, and completed the present invention having the following gist.

That is, the present invention includes the following aspects.
[1] An organic film-forming composition, which is used for forming an organic film that is formed between resist patterns formed from a metal-containing resist film and that is then removed,
   the organic film-forming composition containing: an organic film constituent component; and a solvent.
[2] The organic film-forming composition according to [1], wherein the metal-containing resist film has at least one element of Si, Ge, Sn, Ti, Zr, Hf, Al, and Co.
[3] The organic film-forming composition according to [1], wherein the organic film constituent component contains a polymer (A).
[4] The organic film-forming composition according to [3], wherein the polymer (A) is not water-soluble.
[5] The organic film-forming composition according to [4], wherein the polymer (A) is a polymer (A1) having a ring structure.
[6] The organic film-forming composition according to [5], wherein the polymer (A1) is a polymer (A1-1) having a ring structure in a main chain.
[7] The organic film-forming composition according to [5], wherein the polymer (A1) is a polymer (A1-2) having a ring structure in a side chain.
[8] The organic film-forming composition according to [6], wherein at least one type of ring structure of the main chain in the polymer (A1-1) is a monocyclic aliphatic ring.
[9] The organic film-forming composition according to [8], wherein the polymer (A1-1) is a polymer (X) having a repeating unit represented by formula (X) below: 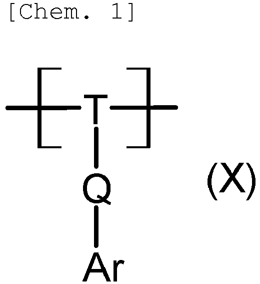
   wherein T represents a group having a monocyclic aliphatic ring constituting a main chain of the polymer (X) ,
   Q represents a divalent linking group, and
   Ar represents an aromatic group which may have a substituent.
[10] The organic film-forming composition according to [6], wherein at least one type of ring structure of the main chain in the polymer (A1-1) is a heterocycle.
[11] The organic film-forming composition according to [10], wherein the polymer (A1-1) is a polymer (Y) having a repeating unit represented by formula (Y) below: 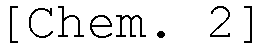 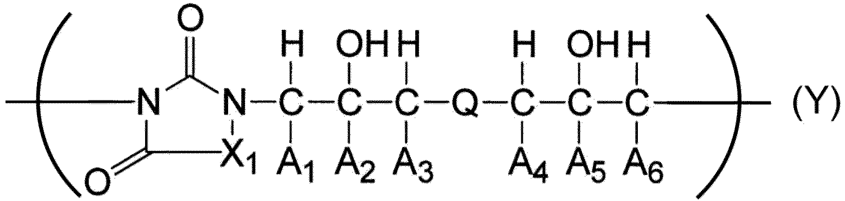
   wherein A₁, A₂, A₃, A₄, A₅, and A₆ each represent a hydrogen atom, a methyl group, or an ethyl group,
   X₁ represents formula (Y2), (Y3), (Y4), or (Y0) below,
   Q represents formula (Y5) or (Y6) below, 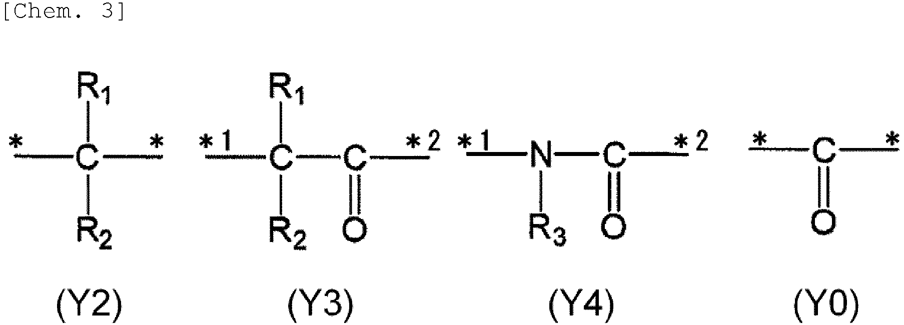
   wherein R₁ and R₂ each represent a hydrogen atom, a halogen atom, an alkyl group having 1 to 6 carbon atoms, an alkenyl group having 3 to 6 carbon atoms, a benzyl group, or a phenyl group, and the alkyl group having 1 to 6 carbon atoms, the alkenyl group having 3 to 6 carbon atoms, the benzyl group, and the phenyl group may be substituted with a group selected from a group consisting of an alkyl group having 1 to 6 carbon atoms, a halogen atom, an alkoxy group having 1 to 6 carbon atoms, a nitro group, a cyano group, a hydroxy group, a carboxyl group, and an alkylthio group having 1 to 6 carbon atoms, R₁ and R₂ may be bonded to each other to form a ring having 3 to 6 carbon atoms,
   R₃ represents a halogen atom, an alkyl group having 1 to 6 carbon atoms, an alkenyl group having 3 to 6 carbon atoms, a benzyl group, or a phenyl group, and the phenyl group may be substituted with a group selected from a group consisting of an alkyl group having 1 to 6 carbon atoms, a halogen atom, an alkoxy group having 1 to 6 carbon atoms, a nitro group, a cyano group, a hydroxy group, and an alkylthio group having 1 to 6 carbon atoms,
   * represents a bond, *1 represents a bond bonded to a carbon atom, and *2 represents a bond bonded to a nitrogen atom, 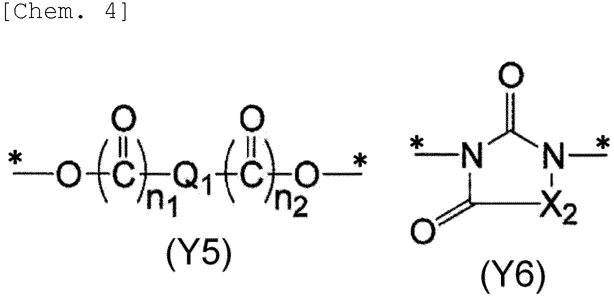
   wherein Q₁ represents an alkylene group having 1 to 10 carbon atoms, a phenylene group, a naphthylene group, or an anthrylene group, and each of the alkylene group, the phenylene group, the naphthylene group, and the anthrylene group may be substituted with an alkyl group having 1 to 6 carbon atoms, a carbonyloxyalkyl group having 2 to 7 carbon atoms, a halogen atom, an alkoxy group having 1 to 6 carbon atoms, a phenyl group, a nitro group, a cyano group, a hydroxy group, an alkylthio group having 1 to 6 carbon atoms, a group having a disulfide group, a carboxyl group, or groups of a combination thereof,
   n₁ and n₂ each represent 0 or 1,
   X₂ represents the formula (Y2), (Y3), or (Y0), and
   * represents a bond.
[12] The organic film-forming composition according to [7], wherein at least one type of ring structure of the side chain in the polymer (A1-2) is a heterocycle.
[13] The organic film-forming composition according to [7], wherein at least one type of ring structure of the side chain in the polymer (A1-2) is a lactone ring.
[14] The organic film-forming composition according to [13], wherein the polymer (A1-2) is a polymer (Z) having a repeating unit represented by formula (Z) below: 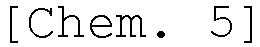 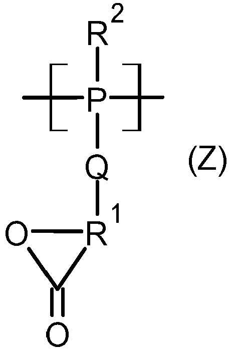
   wherein Q represents a divalent linking group,
   R₁ represents a substituted or unsubstituted trivalent hydrocarbon group having 3 or 4 carbon atoms,
   P represents a bonding group constituting a main chain, and
   R₂ represents a hydrogen atom, a methyl group, or a halogen atom.
[15] The organic film-forming composition according to [4], wherein the polymer (A) is a polymer (A2) having a repeating unit represented by formula (Q) below: 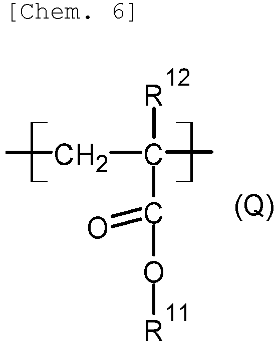
   wherein R¹¹ represents an alkyl group having 1 to 4 carbon atoms, and
   R¹² represents a hydrogen atom, a methyl group, or a halogen atom.
[16] The organic film-forming composition according to any one of [1] to [15], which is used for preventing the resist pattern from collapsing.
[17] The organic film-forming composition according to any one of [1] to [16], which also serves as a developer when the resist pattern is formed.
[18] A method for producing a semiconductor element, the method including:
   a step of irradiating a metal-containing resist film with light or an electron beam;
   a step of bringing a developer into contact with the metal-containing resist film irradiated with light or an electron beam to obtain a resist pattern;
   a step of applying the organic film-forming composition according to any one of [1] to [16] onto the resist pattern without drying the resist pattern with which the developer is in contact to form an organic film between the resist patterns; and
   a step of removing the organic film.
[19] The method for producing a semiconductor element according to [18], wherein in the step of forming the organic film, the organic film is also formed on the resist pattern.
[20] The method for producing a semiconductor element according to [18] or [19], wherein the step of removing the organic film is selected from dry etching, wet etching, radiation etching, high-temperature firing, dissolution removal using a solvent, and an ozone treatment.
[21] A substrate with a metal-containing resist pattern, wherein an organic film is embedded between the metal-containing resist patterns by applying the organic film-forming composition according to any one of [1] to [16] onto a metal-containing resist pattern.
[22] A method for producing a substrate with a metal-containing resist pattern, the method including a step of applying the organic film-forming composition according to any one of [1] to [16] onto a metal-containing resist pattern to embed an organic film between the metal-containing resist patterns.

### Advantageous Effects of Invention

According to the present invention, it is possible to provide an organic film-forming composition capable of preventing pattern collapse in fine patterning with a metal-containing resist film, and a method for producing a semiconductor element using the organic film-forming composition.

### Brief Description of Drawings

Fig. 1A is a schematic cross-sectional view for explaining an embodiment of a method for producing a semiconductor element (part 1).
Fig. 1B is a schematic cross-sectional view for explaining an embodiment of a method for producing a semiconductor element (part 2).
Fig. 1C is a schematic cross-sectional view for explaining an embodiment of a method for producing a semiconductor element (part 3).
Fig. 1D is a schematic cross-sectional view for explaining an embodiment of a method for producing a semiconductor element (part 4).
Fig. 1E is a schematic cross-sectional view for explaining an embodiment of a method for producing a semiconductor element (part 5).
Fig. 2 is a schematic cross-sectional view showing one aspect of an organic film between resist patterns.
Fig. 3A is a schematic cross-sectional view for explaining another embodiment of a method for producing a semiconductor element (part 1).
Fig. 3B is a schematic cross-sectional view for explaining another embodiment of a method for producing a semiconductor element (part 2).
Fig. 3C is a schematic cross-sectional view for explaining another embodiment of a method for producing a semiconductor element (part 3).
Fig. 3D is a schematic cross-sectional view for explaining another embodiment of a method for producing a semiconductor element (part 4).

### Description of Embodiments

### (Organic film-forming composition)

The organic film-forming composition of the present invention is an organic film-forming composition used for forming an organic film that is formed between resist patterns formed from a metal-containing resist film and that is then removed.

The organic film-forming composition contains an organic film constituent component and a solvent.

The present inventors have found that when a resist pattern is formed from a metal-containing resist film, resist pattern collapse is likely to occur after development.

Generally, in the formation of a resist pattern, drying is performed to remove a developer after development.

As a result of repeated studies, the present inventors have found that resist pattern collapse can be prevented by forming an organic film between resist patterns after development and removing the organic film instead of drying and removing a developer after development, and completed the present invention.

The present inventors consider that the resist pattern collapse occurs due to the influence of the capillary force of a developer during drying for removing the developer.

WO 2012/128251 A discloses a developer that is used in a lithography process, and contains a polymer for forming a dry etching mask and an organic solvent (see, for example, claim 1). However, the technical idea is clearly different between the invention described in WO 2012/128251 A and the present invention in that this developer is used for forming a reverse pattern by a contained polymer.

In addition, JP 2011-33842 A discloses a treatment liquid that contains a resin soluble in an organic solvent and an organic solvent, and is used for forming a pattern with a chemically amplified resist composition (see, for example, claim 1). Here, according to paragraph [0013] of JP 2011-33842 A, it is presumed that in this technique, a resin soluble in an organic solvent contributes to promoting penetration of a developer or a rinse liquid into a resist composition and improving a dissolution rate. On the other hand, in the present invention, a metal-containing resist film is used as a resist film. Usually, the resin and the metal-containing resist film are not compatible with each other, and therefore when the resist film is a metal-containing resist film, it cannot be expected that a resin soluble in an organic solvent promotes penetration of a developer or a rinse liquid into a resist composition. In this respect, the technical idea is clearly different between the invention described in JP 2011-33842 A and the present invention.

The metal-containing resist film is not particularly limited, and preferably has at least one element of Si, Ge, Sn, Ti, Zr, Hf, Al, and Co.

The organic film-forming composition is preferably used for preventing the resist pattern from collapsing.

The organic film-forming composition also serves as, for example, a developer for forming a resist pattern.

The method for removing the organic film is not particularly limited, and examples thereof include a method for removing an organic film used in a semiconductor lithography process.

Examples of the method for removing the organic film include dry etching, wet etching (for example, decomposition removal with an acidic liquid), radiation etching, high-temperature firing, dissolution removal using a solvent, and an ozone treatment. One of these can be performed alone, or two or more of these can be performed in combination.

### <Organic film constituent component>

The organic film constituent component is not particularly limited, and examples thereof include a low molecular weight compound, a polymer, a crosslinking agent, a surfactant, a curing catalyst, a filler, and other additives.

The organic film constituent component is a component present in the organic film as it is or while reacting with another component when an organic film is formed from the organic film-forming composition, and can be referred to as a component other than the solvent in the organic film-forming composition.

The organic film constituent component is not particularly limited as long as it contains an organic component, and does not need to all be formed of an organic component, and may contain, for example, an inorganic component.

The organic film constituent component preferably contains a polymer (A).

### <<Polymer (A)>>

The polymer (A) is not particularly limited.

Examples of the polymer (A) include addition polymerization polymers and polycondensation polymers such as polyester, polystyrene, polyimide, an acrylic polymer, a methacrylic polymer, polyvinyl ether, phenol novolac, naphthol novolac, polyether, polyamide, and polycarbonate.

The polymer (A) may be, for example, a polymer (A1), a polymer (A2), or the like described later.

The polymer (A) is not, for example, a polysiloxane.

The polymer (A) may be a homopolymer or a copolymer.

The weight average molecular weight of the polymer (A) is not particularly limited, but is preferably 1,000 to 200,000, more preferably 1,500 to 150,000, and particularly preferably 2,000 to 100,000.

In the present description, the weight average molecular weight is a molecular weight obtained in terms of polystyrene by gel permeation chromatography (GPC) analysis.

The polymer (A) is preferably not water-soluble. In the present description, the expression "water-soluble" refers to that 5 g or more of an object (for example, a polymer) is dissolved in 100 g of water at 25°C. That is, the expression "not water-soluble" refers to that the amount of an object (for example, a polymer) dissolved in 100 g of water at 25°C is less than 5 g. The expression "is dissolved" refers to that no precipitate is visually observed after a solution containing the object dissolved is left for 1 hour at a temperature of 20 to 30°C in the atmosphere. None of the polymers synthesized in Synthesis Examples 1 to 4 in examples in the present description are water-soluble.

The polymer (A) is, for example, a polymer (A1) having a ring structure.

The polymer (A1) is, for example, a polymer (A1-1) having a ring structure in a main chain.

The polymer (A1) is, for example, a polymer (A1-2) having a ring structure in a side chain.

The polymer (A1-1) having a ring structure in a main chain may have a ring structure only in a main chain, or may have a ring structure also in a side chain.

The polymer (A1-2) having a ring structure in a side chain may have a ring structure only in a side chain, or may have a ring structure also in a main chain.

The main chain refers to, for example, a portion formed of the longest chain of atoms in the polymer.

At least one type of ring structure of the main chain in the polymer (A1-1) is, for example, a monocyclic aliphatic ring.

At least one type of ring structure of the main chain in the polymer (A1-1) is, for example, a heterocycle. Examples of the heteroatom constituting the heterocycle include an oxygen atom and a nitrogen atom. Examples of the heterocycle include an isocyanurate ring and a barbituric acid ring.

At least one type of ring structure of a side chain in the polymer (A1-2) is, for example, a heterocycle. Examples of the heteroatom constituting the heterocycle include an oxygen atom and a nitrogen atom. Examples of the heterocycle include 5- to 7-membered rings.

At least one type of ring structure of a side chain in the polymer (A1-2) is, for example, a lactone ring.

### <<<Polymer (X)>>>

The polymer (A1-1) is preferably a polymer (X) having a repeating unit represented by formula (X) below.

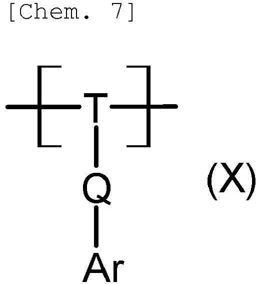

In formula (X), T represents a group having a monocyclic aliphatic ring constituting a main chain of the polymer (X).
Q represents a divalent linking group.
Ar represents an aromatic group which may have a substituent.

The polymer (X) may have two or more types of repeating units represented by formula (X) in which Ar in formula (X) is different.

Examples of the monocyclic aliphatic ring include a cycloalkane ring having 4 to 10 carbon atoms. Among them, a cyclohexane ring is preferred.

The monocyclic aliphatic ring may have a substituent other than -Q-Ar in formula (X). Examples of the substituent include an alkyl group having 1 to 10 carbon atoms, an aryl group having 6 to 20 carbon atoms, a halogen atom, a nitro group, and an amino group.

Examples of the alkyl group having 1 to 10 carbon atoms include a methyl group, an ethyl group, a n-propyl group, an iso-propyl group, a cyclopropyl group, a n-butyl group, an iso-butyl group, a sec-butyl group, a tert-butyl group, a cyclobutyl group, a 1-methyl-cyclopropyl group, a 2-methyl-cyclopropyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-iso-propyl-cyclopropyl group, a 2-iso-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

Examples of the aryl group having 6 to 20 carbon atoms include a phenyl group, an o-methylphenyl group, an m-methylphenyl group, a p-methylphenyl group, an o-chlorophenyl group, an m-chlorophenyl group, a p-chlorophenyl group, an o-fluorophenyl group, a p-fluorophenyl group, an o-methoxyphenyl group, a p-methoxyphenyl group, a p-nitrophenyl group, a p-cyanophenyl group, an α-naphthyl group, a β-naphthyl group, an o-biphenylyl group, an m-biphenylyl group, a p-biphenylyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

In the present invention, examples of the halogen atom include a fluorine atom, a chlorine atom, a bromine atom, and an iodine atom.

The repeating unit represented by formula (X) is preferably a repeating unit represented by formula (Xa) below.

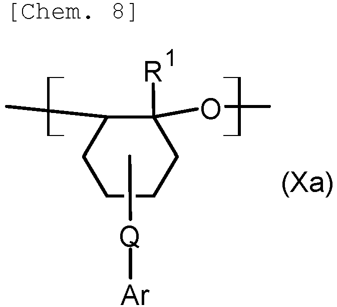

In formula (Xa), R₁ represents a hydrogen atom, an alkyl group having 1 to 10 carbon atoms, an aryl group having 6 to 20 carbon atoms, a halogen atom, a nitro group, or an amino group.
Q represents a divalent linking group.
Ar represents an aromatic group which may have a substituent.

The aromatic ring in the aromatic group of Ar in formulae (X) and (Xa) may be an aromatic hydrocarbon ring or an aromatic heterocycle. The aromatic ring may be a monocycle or a fused ring.

Examples of the aromatic hydrocarbon ring include a benzene ring, a naphthalene ring, and an anthracene ring.

Examples of the substituent of Ar in formulae (X) and (Xa) include an alkyl group having 1 to 10 carbon atoms, an alkoxy group having 1 to 10 carbon atoms, a hydroxy group, a halogen atom, a nitro group, and an amino group.

The number of atoms constituting the divalent linking group in Q in formulae (X) and (Xa) is, for example, 1 to 20.

Examples of Q include the following linking group (Qa) .

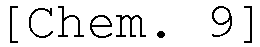

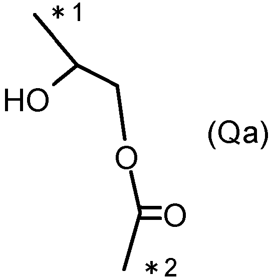

In formula (Qa), *1 represents a bond bonded to a monocyclic aliphatic ring. *2 represents a bond bonded to an aromatic ring.

The polymer (X) is, for example, a reaction product of a polymer (X1) having a repeating unit represented by formula (X1) below and an aromatic carboxylic acid (X2).

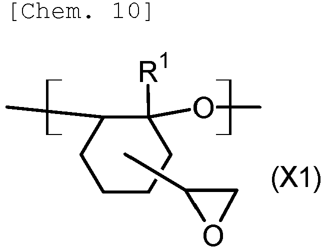

In formula (Xa), R₁ represents a hydrogen atom, an alkyl group having 1 to 10 carbon atoms, an aryl group having 6 to 20 carbon atoms, a halogen atom, a nitro group, or an amino group.

As the polymer having a repeating unit represented by formula (X1), a commercially available product may be used. Examples of the commercially available product include EHPE 3150 (manufactured by Daicel Chemical Industries, Ltd.).

Examples of the aromatic carboxylic acid (X2) include a monocyclic aromatic carboxylic acid and a fused ring aromatic carboxylic acid.

Examples of the monocyclic aromatic carboxylic acid include benzoic acid.

Examples of the fused ring aromatic carboxylic acid include naphthalene carboxylic acid and anthracene carboxylic acid.

Examples of the polymer (X) include the following polymers (X-1) to (X-12). The following polymers have two or three types of repeating units.

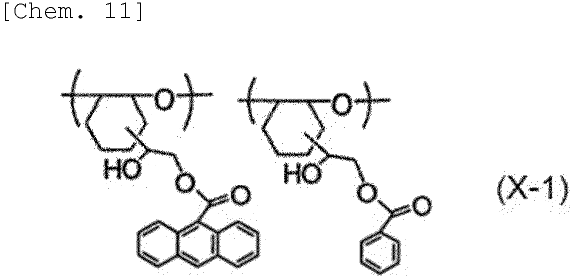

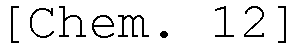

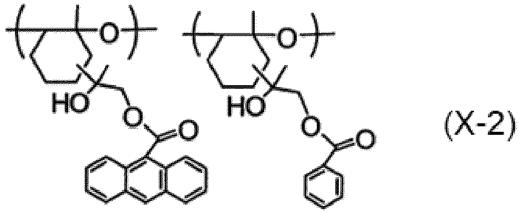

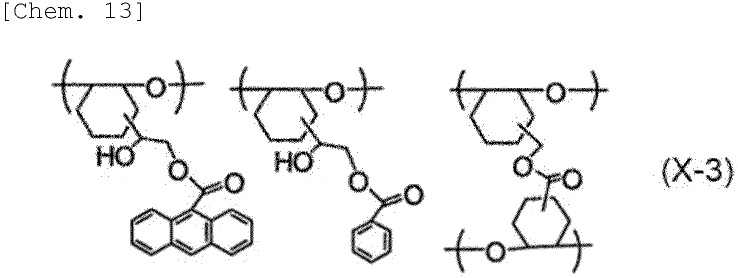

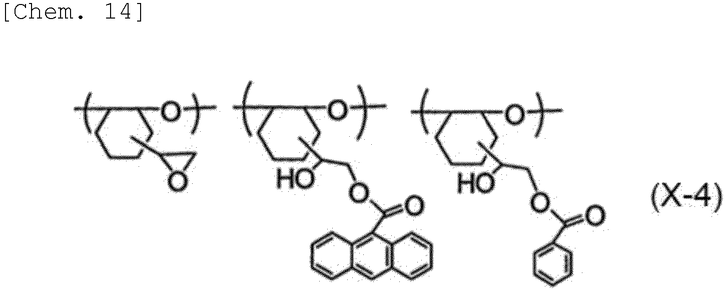

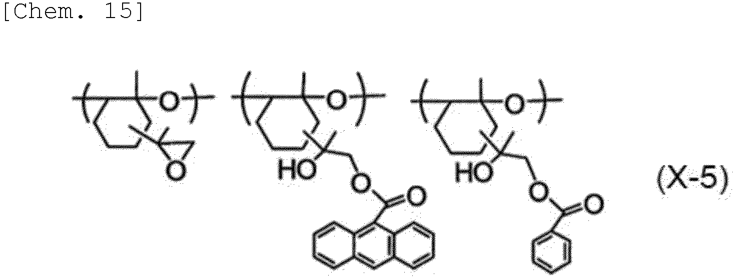

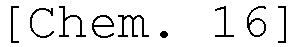

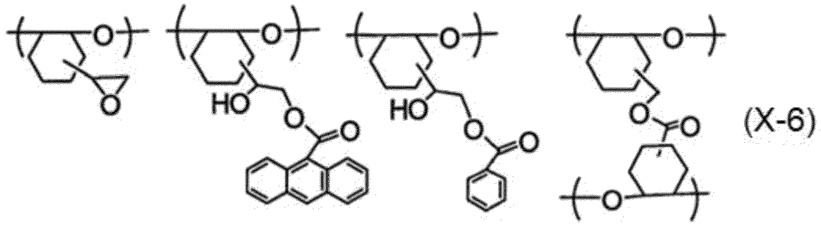

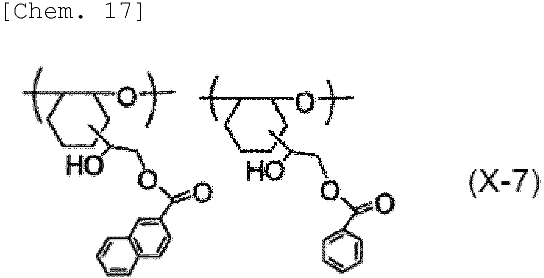

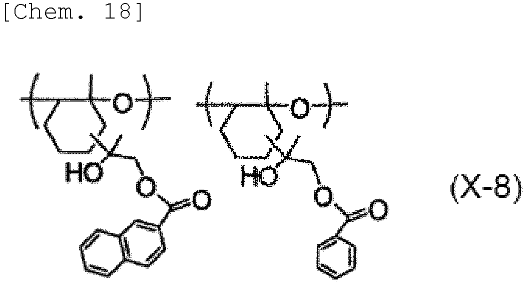

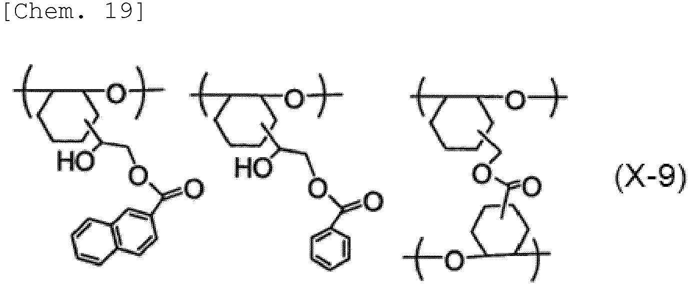

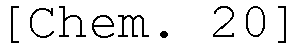

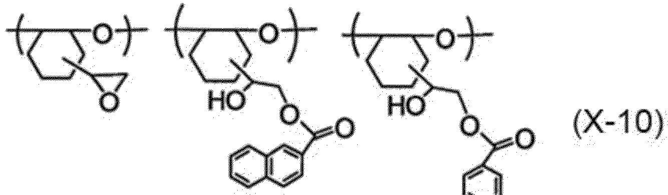

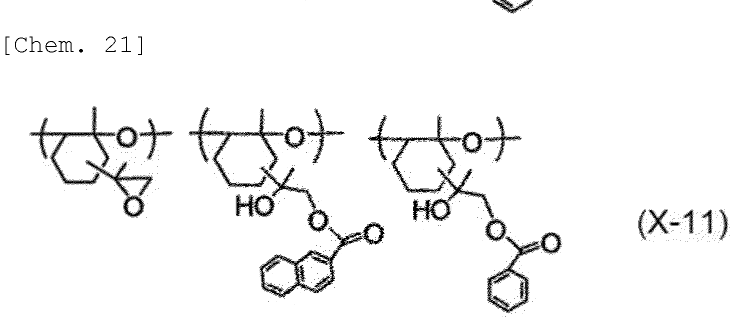

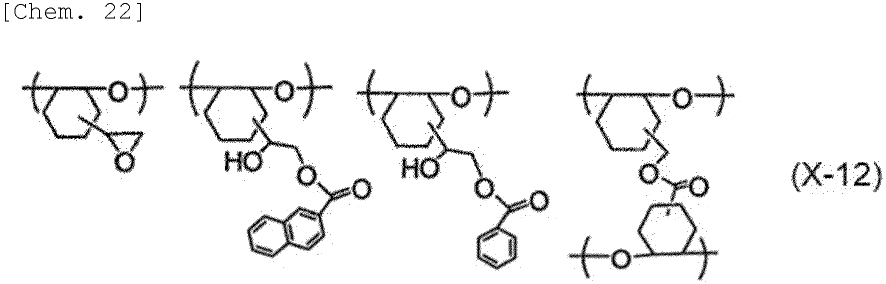

Examples of the polymer (X) include polymers described in WO 2011/021555 A. The contents of WO 2011/021555 A are hereby incorporated in their entireties by reference, to the extent that they have been disclosed herein.

The weight average molecular weight of the polymer (X) is not particularly limited, but is preferably 1,000 to 15,000, more preferably 1,500 to 10,000, and particularly preferably 2,000 to 7,000.

### <<<Polymer (Y)>>>

The polymer (A1-1) is preferably a polymer (Y) having a repeating unit represented by formula (Y) below.

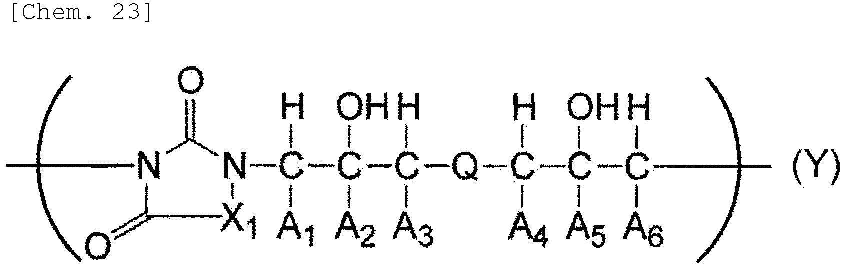

In formula (Y), A₁, A₂, A3, A_{4,} A₅, and A₆ each represent a hydrogen atom, a methyl group, or an ethyl group.
X₁ represents formula (Y2), (Y3), (Y4), or (Y0) below.
Q represents formula (Y5) or (Y6) below.

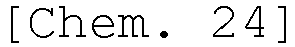

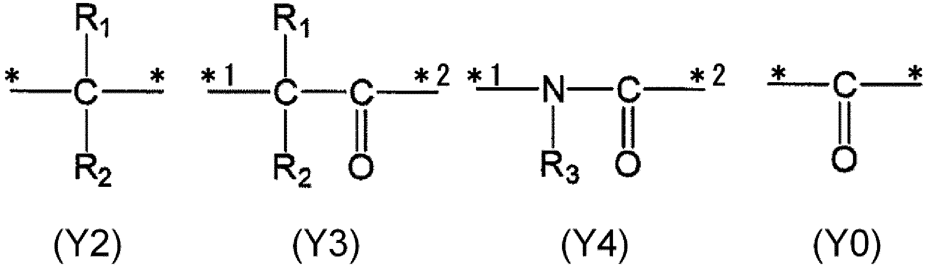

In formulae (Y2), (Y3), (Y4), and (Y0), R₁ and R₂ each represent a hydrogen atom, a halogen atom, an alkyl group having 1 to 6 carbon atoms, an alkenyl group having 3 to 6 carbon atoms, a benzyl group, or a phenyl group, and the alkyl group having 1 to 6 carbon atoms, the alkenyl group having 3 to 6 carbon atoms, the benzyl group, and the phenyl group may be substituted with a group selected from the group consisting of an alkyl group having 1 to 6 carbon atoms, a halogen atom, an alkoxy group having 1 to 6 carbon atoms, a nitro group, a cyano group, a hydroxy group, a carboxyl group, and an alkylthio group having 1 to 6 carbon atoms. R₁ and R₂ may be bonded to each other to form a ring having 3 to 6 carbon atoms.

R₃ represents a halogen atom, an alkyl group having 1 to 6 carbon atoms, an alkenyl group having 3 to 6 carbon atoms, a benzyl group, or a phenyl group, and the phenyl group may be substituted with a group selected from the group consisting of an alkyl group having 1 to 6 carbon atoms, a halogen atom, an alkoxy group having 1 to 6 carbon atoms, a nitro group, a cyano group, a hydroxy group, and an alkylthio group having 1 to 6 carbon atoms.

* represents a bond. *1 represents a bond bonded to a carbon atom. *2 represents a bond bonded to a nitrogen atom.

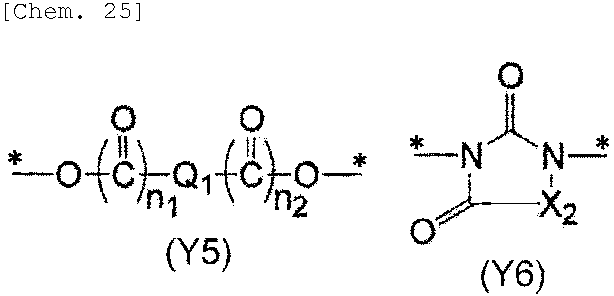

In formulae (Y5) and (Y6), Q₁ represents an alkylene group having 1 to 10 carbon atoms, a phenylene group, a naphthylene group, or an anthrylene group, and each of the alkylene group, the phenylene group, the naphthylene group, and the anthrylene group may be substituted with an alkyl group having 1 to 6 carbon atoms, a carbonyloxyalkyl group having 2 to 7 carbon atoms, a halogen atom, an alkoxy group having 1 to 6 carbon atoms, a phenyl group, a nitro group, a cyano group, a hydroxy group, an alkylthio group having 1 to 6 carbon atoms, a group having a disulfide group, a carboxyl group, or groups of a combination thereof.

n₁ and n₂ each represent 0 or 1.

X₂ represents the formula (Y2), (Y3), or (Y0).

* represents a bond.

Examples of the repeating unit represented by formula (Y) include repeating units represented by formulae (Y-1) to (Y-20) below.

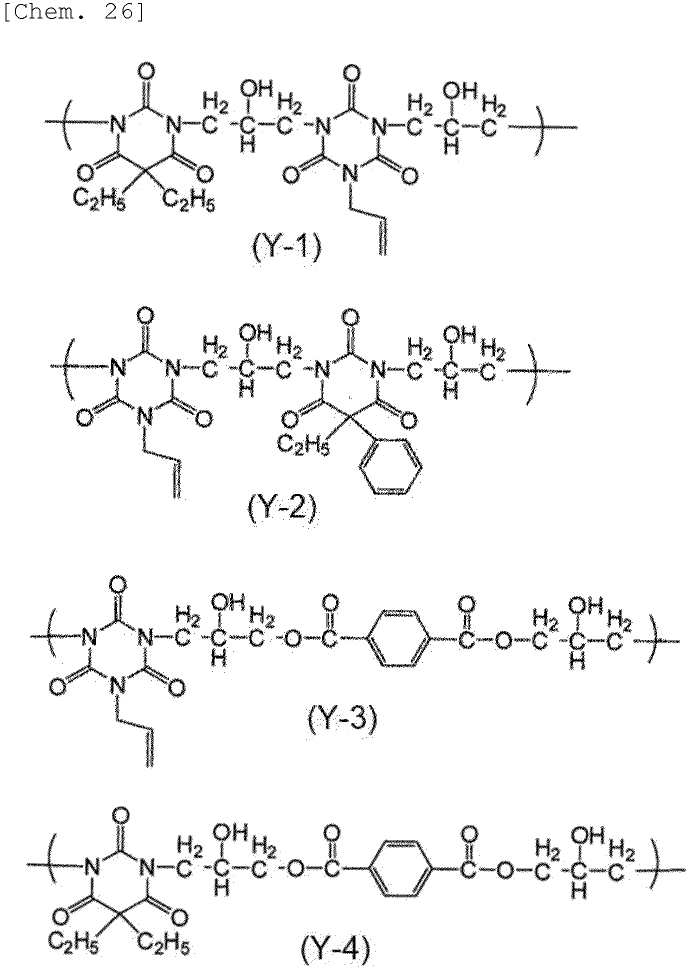

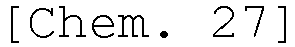

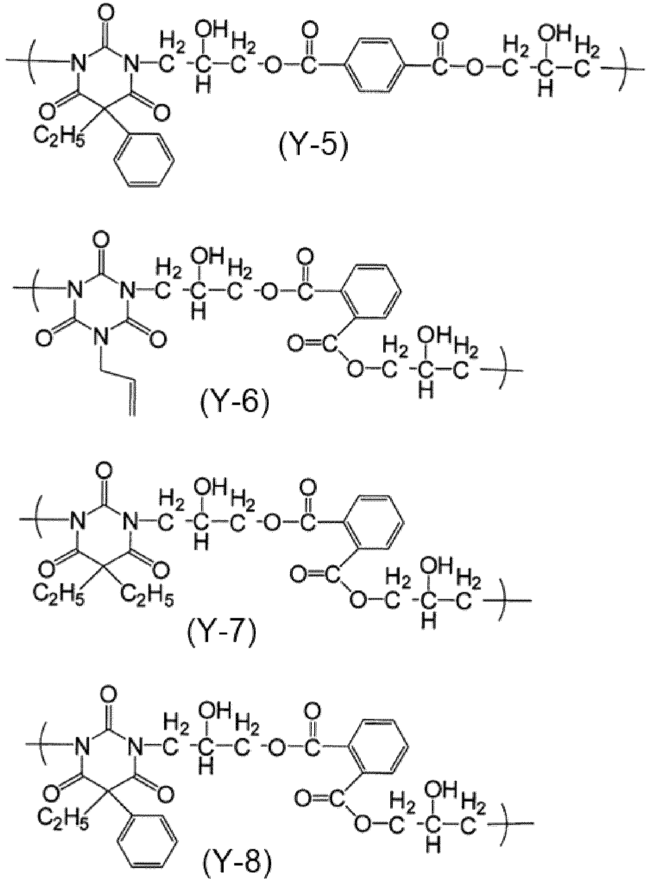

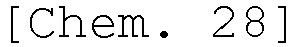

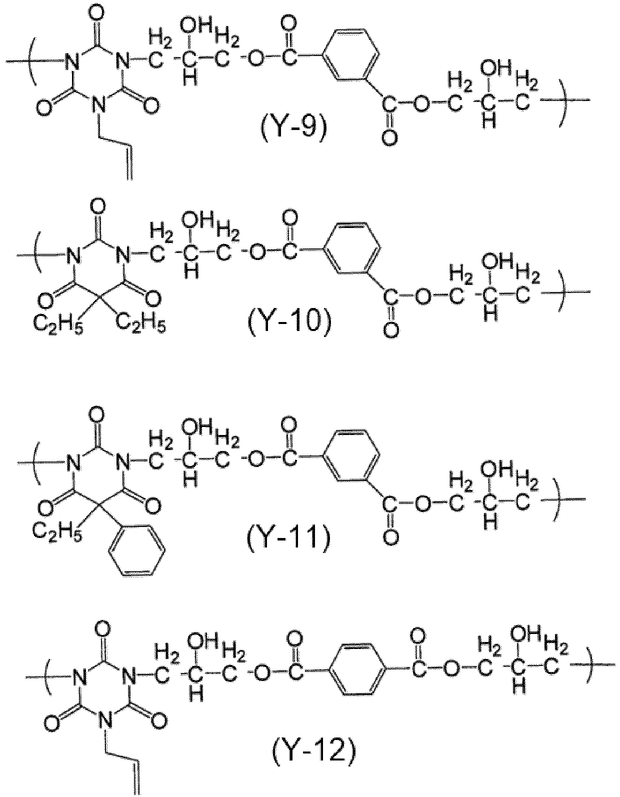

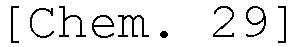

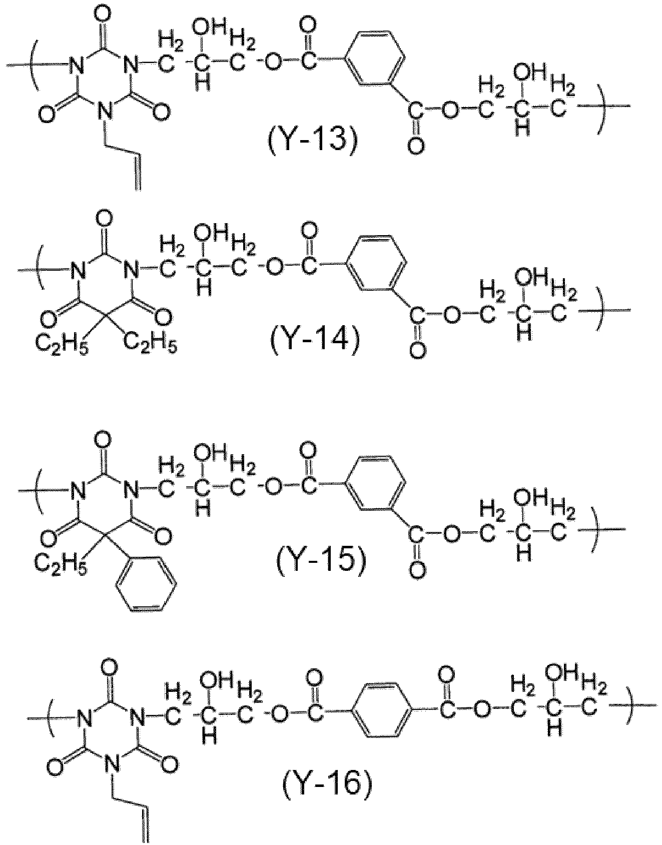

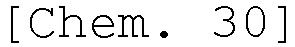

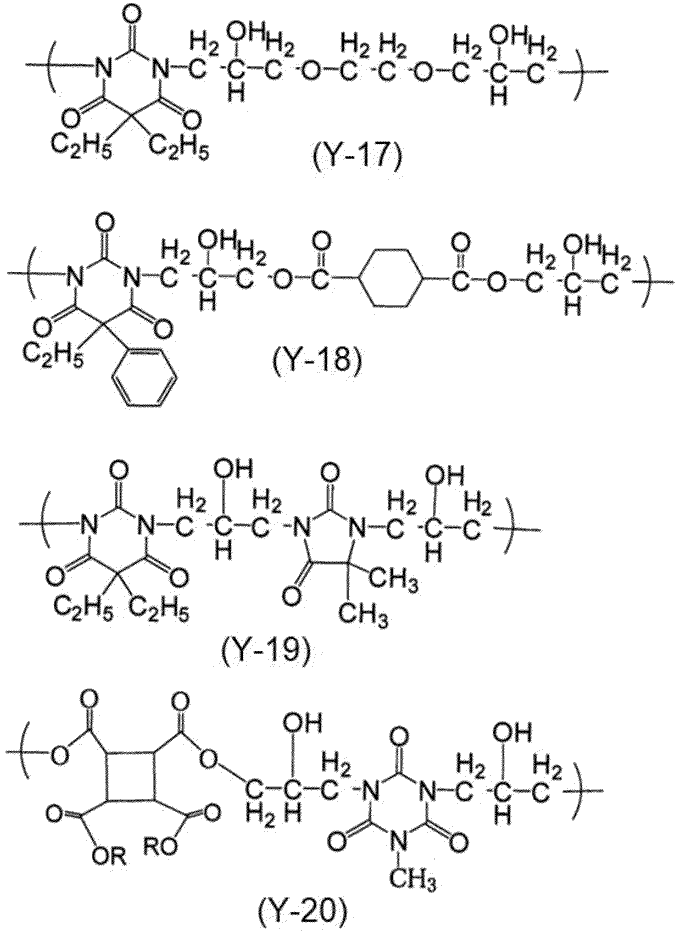

In formula (Y-20), R is an alcohol residue (an organic group other than a hydroxy group of an alcohol), and R represents an alkyl group, an ether group, or a combination thereof. Examples of R include an alkyl group and an alkoxyalkyl group.

Examples of the polymer (Y) include polymers described in WO 2013/018802 A. The contents of WO 2013/018802 A are hereby incorporated in their entireties by reference, to the extent that they have been disclosed herein.

The weight average molecular weight of the polymer (Y) is not particularly limited, but is preferably 1,000 to 30,000, more preferably 2,000 to 20,000, and particularly preferably 3,000 to 15,000.

### <<<Polymer (Z)>>>

The polymer (A1-2) is preferably a polymer (Z) having a repeating unit represented by formula (Z) below.

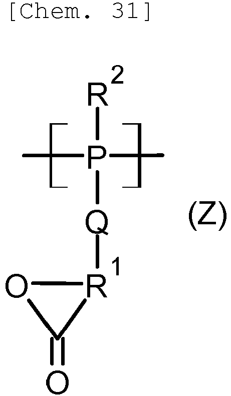

In formula (Z), Q represents a divalent linking group.

R₁ represents a substituted or unsubstituted trivalent hydrocarbon group having 3 or 4 carbon atoms.

P represents a bonding group constituting the main chain.

R₂ represents a hydrogen atom, a methyl group, or a halogen atom.

The repeating unit represented by formula (Z) is preferably a repeating unit represented by formula (Za) below.

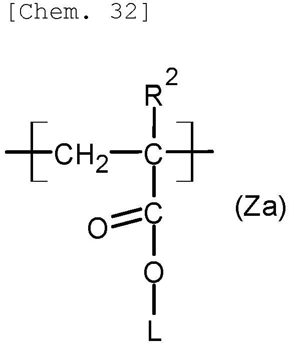

In formula (Za), R₂ represents a hydrogen atom, a methyl group, or a halogen atom.

L represents formula (L-1) or (L-2) below.

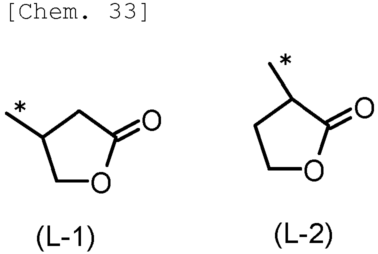

In formulae (L-1) and (L-2), * represents a bond.

The polymer (Z) may have a repeating unit represented by formula (Z-2) below.

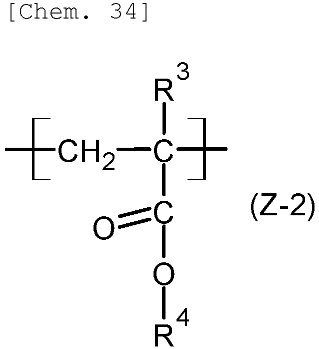

In formula (Z-2), R₃ represents a hydrogen atom, a methyl group, or a halogen atom.

R⁴ represents a hydrogen atom, a substituted or unsubstituted alkyl group having 1 to 10 carbon atoms, a substituted or unsubstituted aralkyl group, a substituted or unsubstituted carbocyclic aromatic group, or a substituted or unsubstituted heterocyclic aromatic group.

Examples of the repeating unit represented by formula (Z-2) include a repeating unit represented by formula (Z-2-1) below and a repeating unit represented by formula (Z-2-2) below.

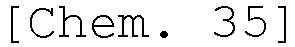

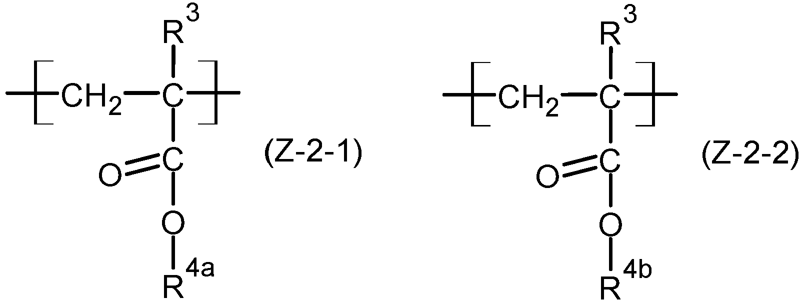

In formulae (Z-2-1) and (Z-2-2), R₃ represents a hydrogen atom, a methyl group, or a halogen atom.

R^{4a} represents an alkyl group having 1 to 4 carbon atoms and substituted with a hydroxy group.

R^{4b} represents a substituted or unsubstituted carbocyclic aromatic group.

Examples of the substituted or unsubstituted alkyl group having 1 to 10 carbon atoms in R⁴ in formula (Z-2) include an alkyl group having 1 to 10 carbon atoms, and an alkyl group having 1 to 4 carbon atoms and substituted with a hydroxy group.

Examples of the substituted or unsubstituted carbocyclic aromatic group in R⁴ in formula (Z-2) and R^{4b} in formula (Z-2-2) include a phenyl group, a benzyl group, a naphthyl group, an anthryl group, and an anthrylmethyl group.

Examples of the alkyl group having 1 to 4 carbon atoms and substituted with a hydroxy group include a 2-hydroxyethyl group and a 2-hydroxypropyl group.

The polymer (Z) may have another repeating unit. Examples of a monomer from which another repeating unit is derived include acrylamides, methacrylamides, allyl compounds, vinyl ethers, vinyl esters, styrenes, and crotonic acid esters.

Examples of the acrylamides include acrylamide, N-alkylacrylamide, N-arylacrylamide, N,N-dialkylacrylamide, N,N-diarylacrylamide, N-methyl-N-phenylacrylamide, and N-2-acetamidoethyl-N-acetylacrylamide.

Examples of the methacrylamides include methacrylamide, N-alkyl methacrylamide, N-aryl methacrylamide, N,N-dialkyl methacrylamide, N,N-diaryl methacrylamide, N-methyl-N-phenyl methacrylamide, and N-ethyl-N-phenyl methacrylamide.

Examples of the vinyl ethers include alkyl vinyl ethers and vinyl aryl ethers.

Examples of the vinyl esters include vinyl butyrate, vinyl isobutyrate, and vinyl trimethyl acetate.

Examples of the styrenes include styrene, alkylstyrene, alkoxystyrene, halogenated styrene, and carboxystyrene.

Examples of the crotonic acid esters include alkyl crotonates such as butyl crotonate, hexyl crotonate, and glycerin monocrotonate.

Additional examples thereof include dialkyl itaconates, dialkyl esters or monoalkyl esters of maleic acid or fumaric acid, crotonic acid, itaconic acid, maleic anhydride, acrylonitrile, methacrylonitrile, and maleonitrile.

Examples of the polymer (Z) include polymers described in WO 03/017002 A. The contents of WO 03/017002 A are hereby incorporated in their entireties by reference, to the extent that they have been disclosed herein.

The weight average molecular weight of the polymer (Z) is not particularly limited, but is preferably 10,000 to 200,000, more preferably 30,000 to 150,000, and particularly preferably 50,000 to 100,000.

### <<<Polymer (Q)>>>

The polymer (A) is preferably a polymer (A2) having a repeating unit represented by formula (Q) below.

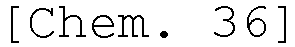

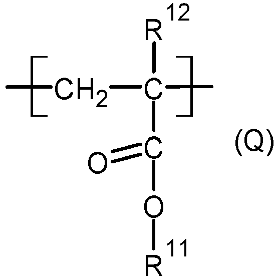

In formula (Q), R¹¹ represents an alkyl group having 1 to 4 carbon atoms.

R¹² represents a hydrogen atom, a methyl group, or a halogen atom.

The polymer (A2) may be a homopolymer or a copolymer.

When the polymer (A2) is a homopolymer, for example, polymethyl methacrylate is preferred as the polymer (A2).

When the polymer (A2) is a copolymer, the polymer (A2) may have a repeating unit represented by formula (Z-2) as a repeating unit other than the repeating unit represented by formula (Q).

When the polymer (A2) is a copolymer, the polymer (A2) may have a repeating unit derived from an acrylamide, a methacrylamide, an allyl compound, a vinyl ether, a vinyl ester, a styrene, a crotonic acid ester, or the like.

The weight average molecular weight of the polymer (Q) is not particularly limited, but is preferably 1,000 to 30,000, more preferably 2,000 to 20,000, and particularly preferably 3,000 to 15,000.

The content of the polymer (A) in the organic film-forming composition is not particularly limited, and is preferably 30 mass% to 100 mass%, more preferably 50 mass% to 100 mass%, and particularly preferably 70 mass% to 100 mass% with respect to the organic film constituent component.

### <<Crosslinking agent>>

The crosslinking agent is not particularly limited.

The crosslinking agent has a structure different from that of the polymer (A).

As the crosslinking agent, an aminoplast crosslinking agent and a phenoplast crosslinking agent are preferred.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent include a compound having two or more structures shown below.

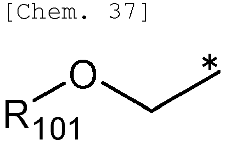

In the structure, R₁₀₁ represents a hydrogen atom, an alkyl group having 1 to 4 carbon atoms, or an alkoxyalkyl group having 2 to 6 carbon atoms. * represents a bond.

The bond is bonded to, for example, a nitrogen atom, a carbon atom constituting an aromatic hydrocarbon ring, or the like.

As R₁₀₁, a hydrogen atom, a methyl group, an ethyl group, or a group represented by the following structure is preferred.

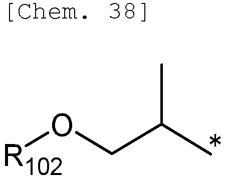

In the structure, R₁₀₂ represents a hydrogen atom, a methyl group, or an ethyl group. * represents a bond.

The crosslinking agent is preferably a melamine compound, a guanamine compound, a glycoluril compound, a urea compound, or a compound having a phenolic hydroxy group. One of these can be used alone, or two or more of these can be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by formula (1E) below.

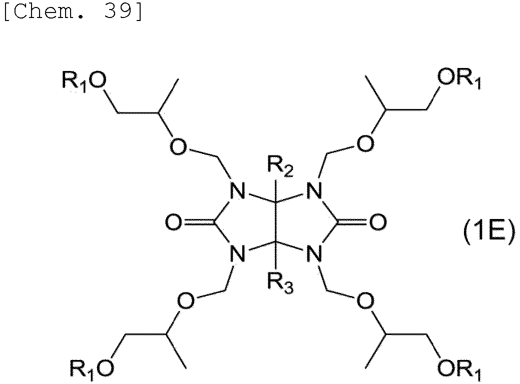

In formula (1E), four R₁'s each independently represent a methyl group or an ethyl group, and R₂ and R₃ each independently represent a hydrogen atom, an alkyl group having 1 to 4 carbon atoms, or a phenyl group.

Examples of the glycoluril derivative represented by formula (1E) include compounds represented by formulae (1E-1) to (1E-6) below.

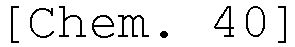

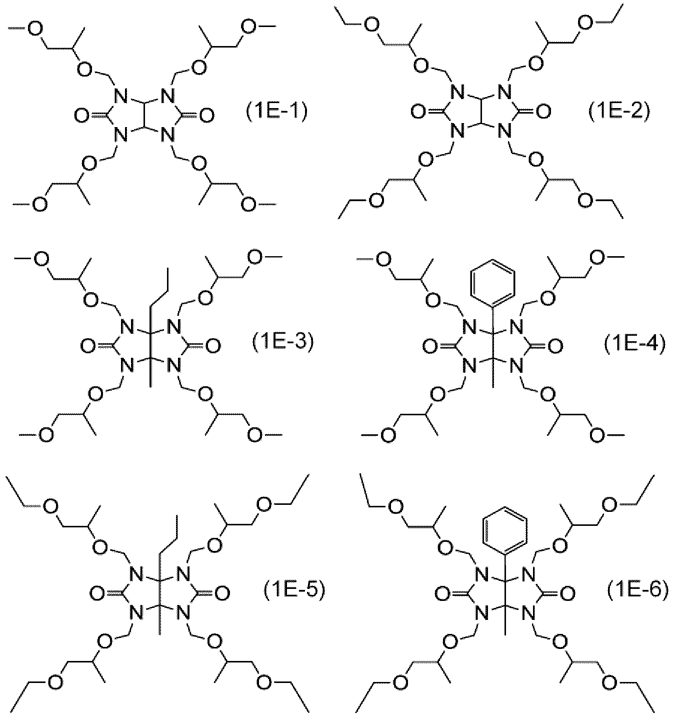

The glycoluril derivative represented by formula (1E) is obtained, for example, by allowing a glycoluril derivative represented by formula (2E) below to react with at least one compound represented by formula (3d) below. 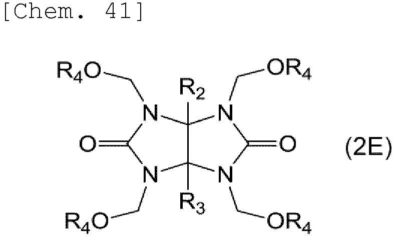 In formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.

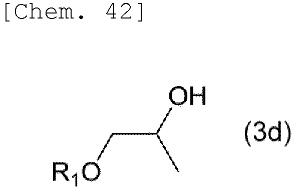

In formula (3d), R₁ represents a methyl group or an ethyl group.

Examples of the glycoluril derivative represented by formula (2E) include compounds represented by formulae (2E-1) to (2E-4) below. Further, examples of the compound represented by formula (3d) include compounds represented by formulae (3d-1) and (3d-2) below.

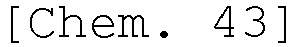

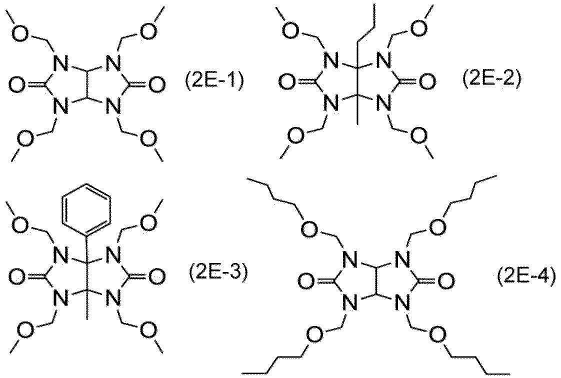

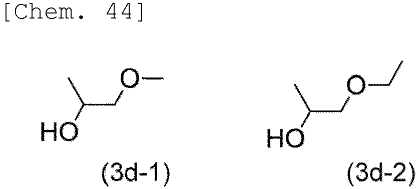

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include a compound represented by formula (G-1) or (G-2) below.

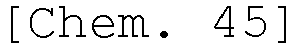

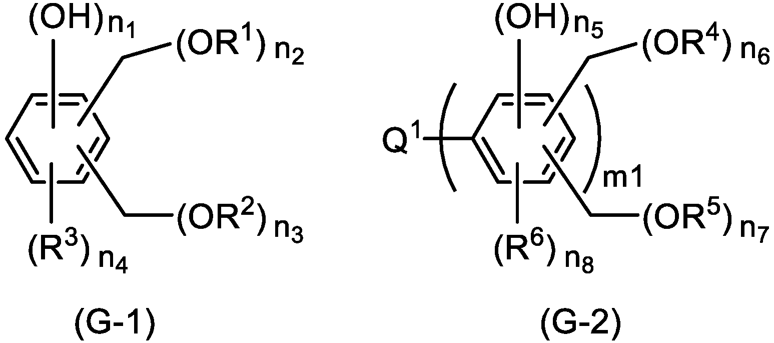

In formulae (G-1) and (G-2), Q₁ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, and n₄ represents an integer that meets 0 ≤ n₄ ≤ 3, and an integer that meets 3 ≤ (n₁ + n₂ + n₃ + n₄) ≤ 6.

n₅ represents an integer that meets 1 ≤ n₅ ≤ 3, n₆ represents an integer that meets 1 ≤ n₆ ≤ 4, n₇ represents an integer that meets 0 ≤ n₇ ≤ 3, and n₈ represents an integer that meets 0 ≤ n₈ ≤ 3, and an integer that meets 2 ≤ (n₅ + n₆ + n₇ + n₈) ≤ 5.

m1 represents an integer of 2 to 10.

Examples of the compound having a phenolic hydroxy group include a compound represented by formula (G-3) or (G-4) below.

The compound represented by formula (G-1) or (G-2) may be obtained by a reaction of a compound represented by formula (G-3) or (G-4) below with a hydroxyl group-containing ether compound or an alcohol having 2 to 10 carbon atoms.

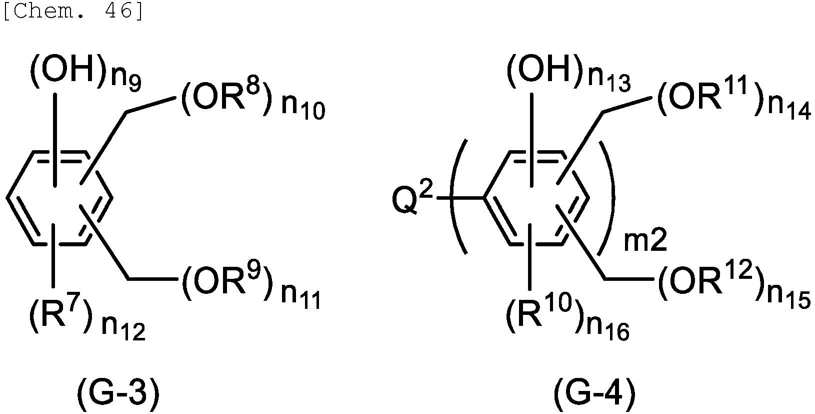

In formulae (G-3) and (G-4), Q² represents a single bond or an m2-valent organic group.

R⁸, R⁹, R¹¹, and R¹² each represent a hydrogen atom or a methyl group.

R⁷ and R¹⁰ each represent an alkyl group having 1 to 10 carbon atoms or an aryl group having 6 to 40 carbon atoms.

n₉ represents an integer that meets 1 ≤ n₉ ≤ 3, n₁₀ represents an integer that meets 2 ≤ n₁₀ ≤ 5, n₁₁ represents an integer that meets 0 ≤ n₁₁ ≤ 3, and n₁₂ represents an integer that meets 0 ≤ n₁₂ ≤ 3, and an integer that meets 3 ≤ (n₉ + n₁₀ + n₁₁ + n₁₂) ≤ 6.

n₁₃ represents an integer that meets 1 ≤ n₁₃ ≤ 3, n₁₄ represents an integer that meets 1 ≤ n₁₄ ≤ 4, n₁₅ represents an integer that meets 0 ≤ n₁₅ ≤ 3, and n₁₆ represents an integer that meets 0 ≤ n₁₆ ≤ 3, and an integer that meets 2 ≤ (n₁₃ + n₁₄ + n₁₅ + n₁₆) ≤ 5.

m2 represents an integer of 2 to 10.

Examples of the m2-valent organic group in Q² include an m2-valent organic group having 1 to 4 carbon atoms.

Examples of the compound represented by formula (G-1) or (G-2) include the following compounds.

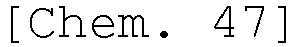

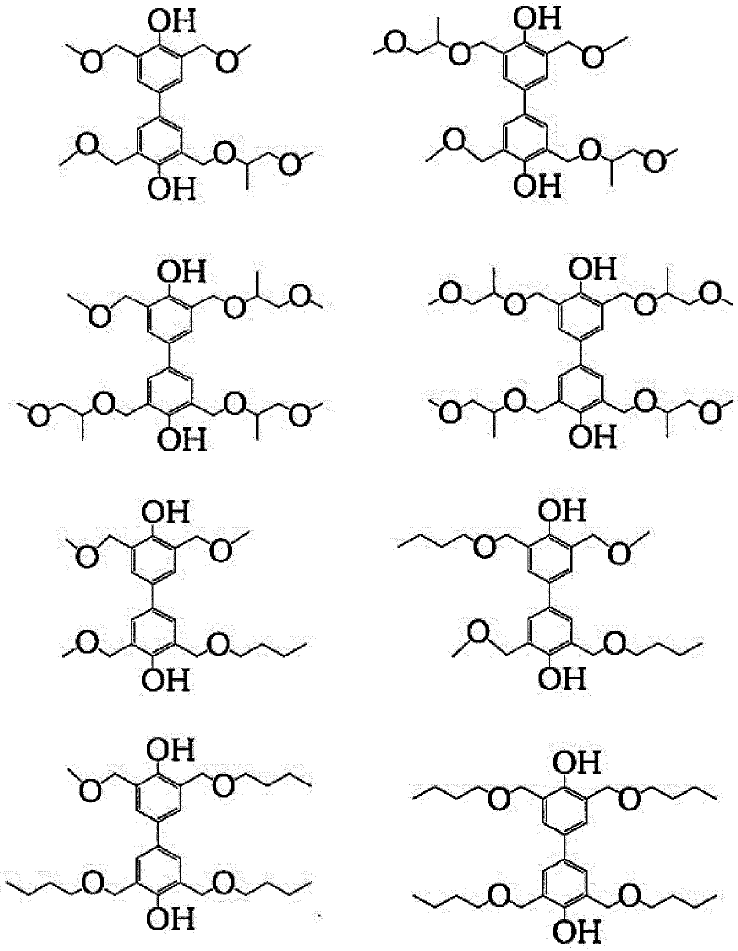

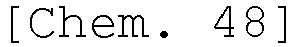

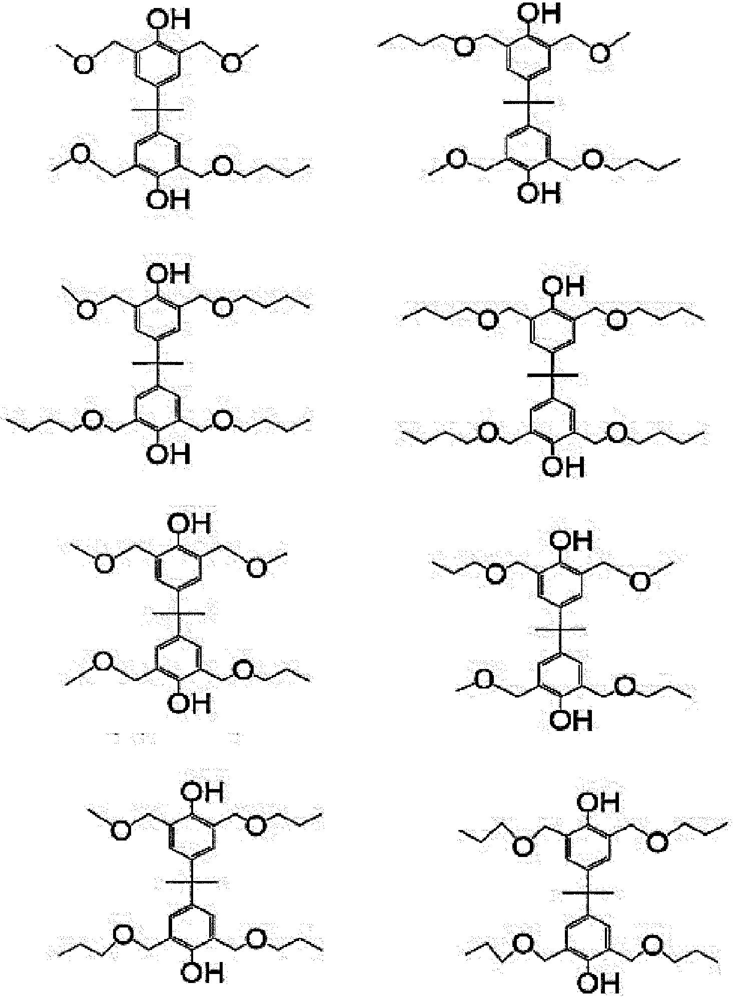

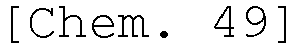

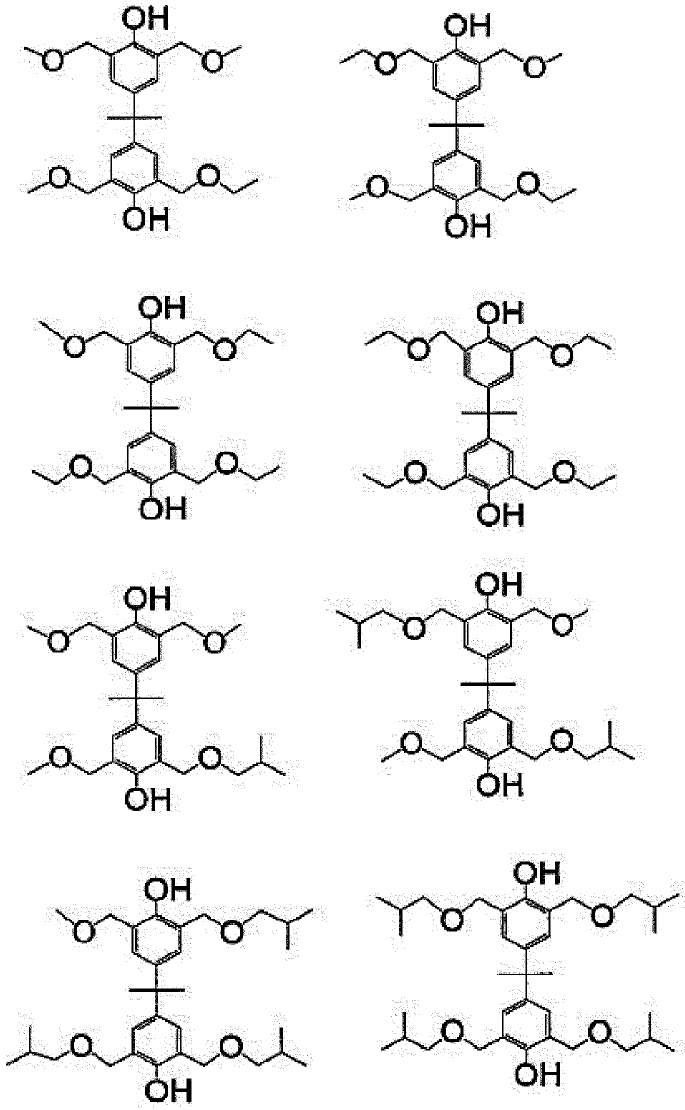

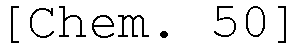

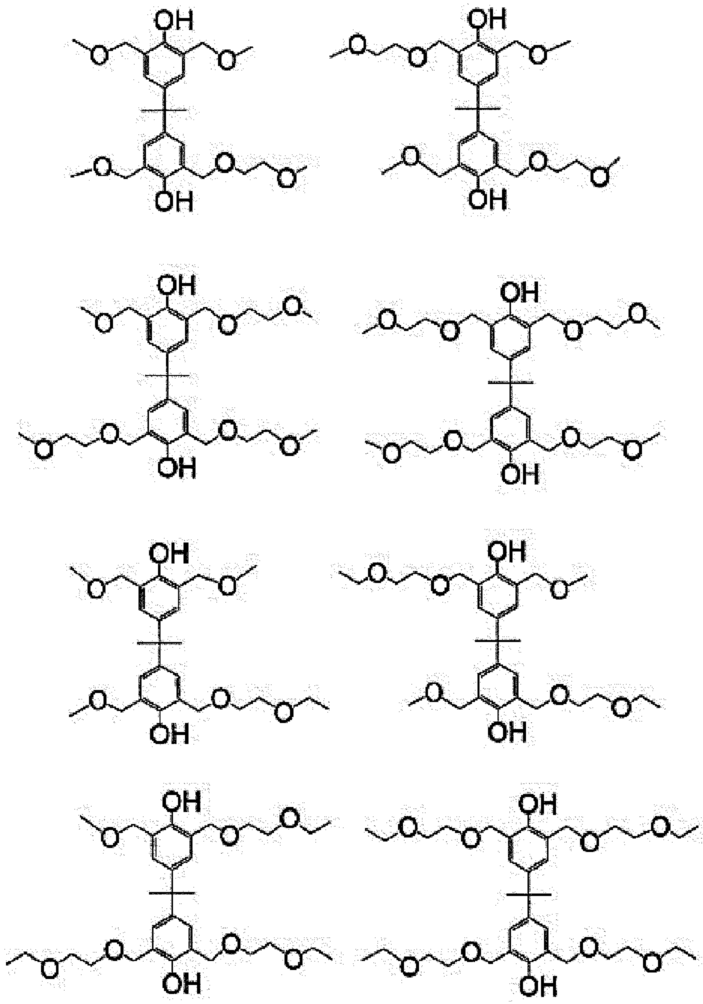

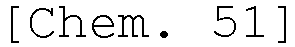

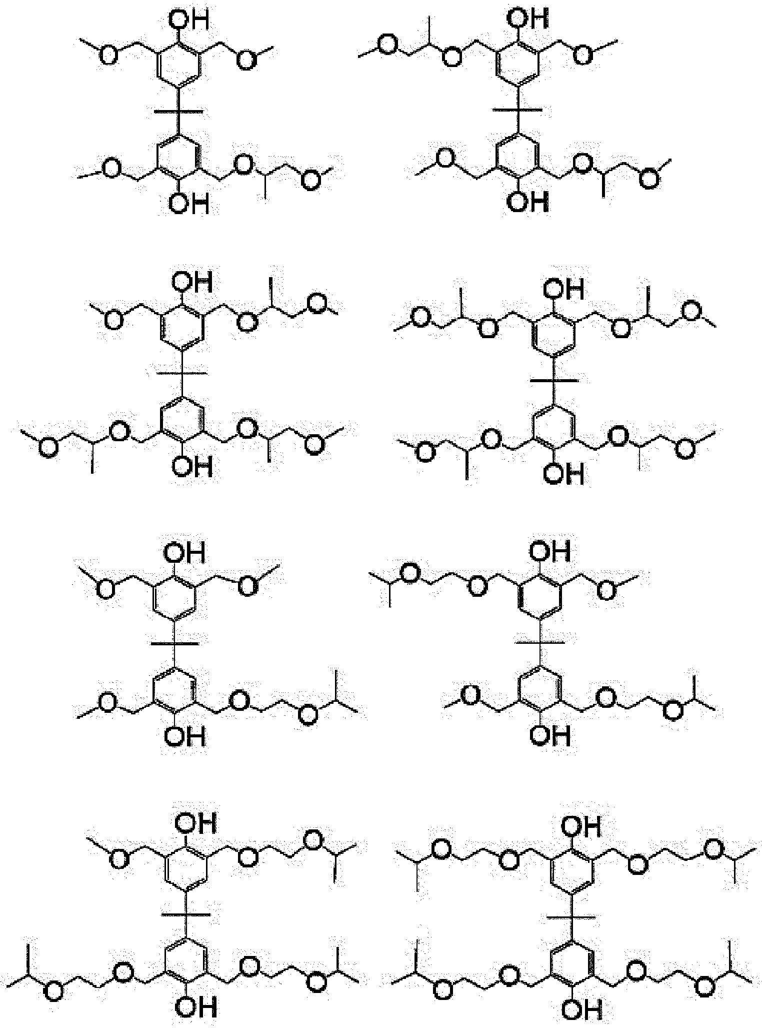

Examples of the compound represented by formula (G-3) or (G-4) include the following compounds.

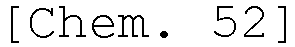

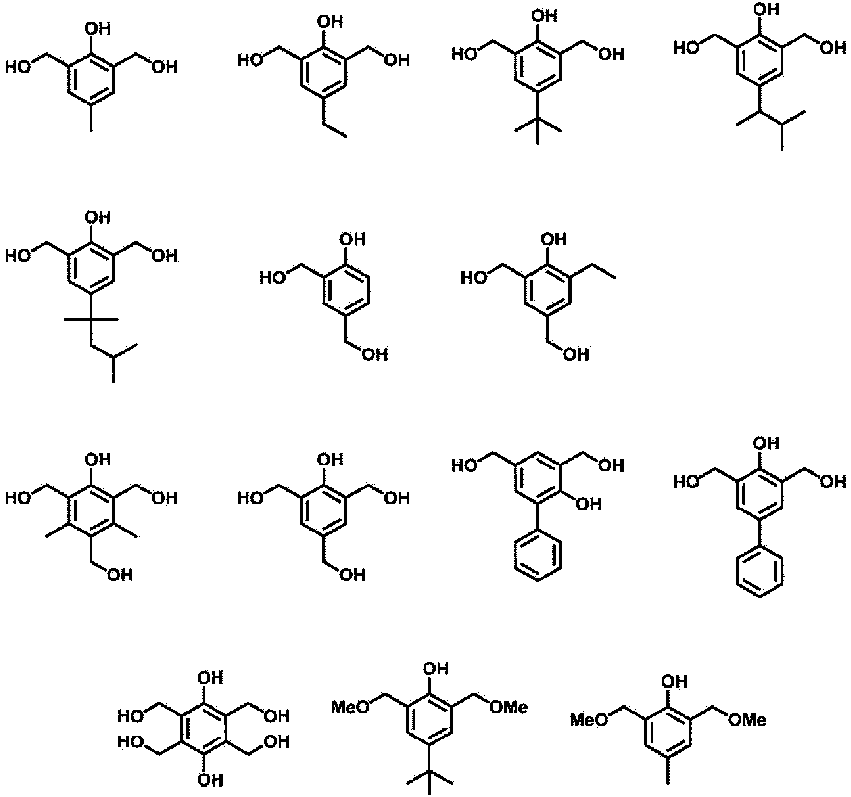

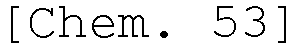

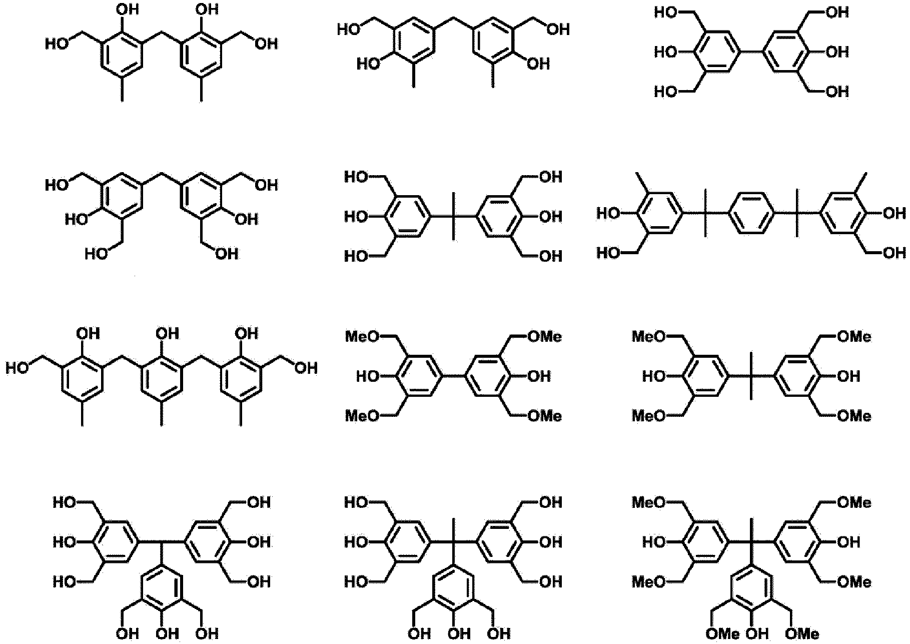

The compounds can be obtained as products of Asahi Organic Chemicals Industry Co., Ltd., and Honshu Chemical Industry Co., Ltd. Examples of the product include TMOM-BP (trade name) of Asahi Organic Chemicals Industry Co., Ltd.

Among them, a glycoluril compound is preferred, and specifically, tetramethylolglycoluril, tetramethoxyglycoluril, tetramethoxymethylglycoluril, a compound in which 1 to 4 methylol groups of tetramethylolglycoluril are methoxymethylated or a mixture thereof, or a compound in which 1 to 4 methylol groups of tetramethylolglycoluril are acyloxymethylated or a mixture thereof is preferred, and tetramethoxymethylglycoluril is more preferred.

The molecular weight of the crosslinking agent is not particularly limited, but is preferably 500 or less.

When the organic film-forming composition contains a crosslinking agent, the content of the crosslinking agent in the organic film-forming composition is not particularly limited, but is, for example, 1 mass% to 70 mass%, preferably 5 mass% to 60 mass% with respect to the polymer (A).

### <<Curing catalyst>>

As the curing catalyst as the organic film constituent component contained as an optional component in the organic film-forming composition, either of a thermal acid generator and a photoacid generator can be used, but it is preferred to use a thermal acid generator.

Examples of the thermal acid generator include sulfonic acid compounds and carboxylic acid compounds such as p-toluenesulfonic acid, trifluoromethanesulfonic acid, pyridinium p-toluenesulfonate (pyridinium p-toluenesulfonic acid), pyridinium phenolsulfonate, pyridinium p-hydroxybenzenesulfonate (p-phenolsulfonic acid pyridinium salt), pyridinium trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonic acid, N-methylmorpholine-p-hydroxybenzenesulfonic acid, and N-methylmorpholine-5-sulfosalicylic acid.

Examples of the photoacid generator include an onium salt compound, a sulfonimide compound, and a disulfonyl diazomethane compound.

Examples of the onium salt compound include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Examples of the disulfonyl diazomethane compound include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl p-toluenesulfonyl diazomethane.

Only one type of curing catalyst can be used, or two or more types thereof can be used in combination.

When a curing catalyst is used, the content ratio of the curing catalyst is, for example, 0.1 mass% to 50 mass%, preferably 1 mass% to 30 mass% with respect to the crosslinking agent.

### <<Other components>>

In the organic film-forming composition, as the organic film constituent component, a surfactant can be further added in order to further improve the coating property against surface unevenness without formation of pinholes, striations, or the like.

Examples of the surfactant include nonionic surfactants including polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl allyl ethers such as polyoxyethylene octylphenol ether and polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (trade name, manufactured by Tochem Products Co., Ltd.), MEGAFAC F171, F173, and R-30 (trade name, manufactured by DIC Corporation), Fluorad FC430 and FC431 (trade name, manufactured by Sumitomo 3M Limited), Asahi Guard AG710, Surflon S-382, SC101, SC102, SC103, SC104, SC105, and SC106 (trade name, manufactured by AGC Corporation), and an organosiloxane polymer KP341 (manufactured by Shin-Etsu Chemical Co., Ltd.).

The blending amount of these surfactants is usually 2.0% by mass or less, and preferably 1.0% by mass or less with respect to the total solid content of the organic film-forming composition.

One of these surfactants may be added alone, or two or more of these surfactants can be added in combination.

### <Solvent>

The solvent used in the organic film-forming composition is not particularly limited, but an organic solvent generally used in a chemical solution for a semiconductor lithography process is preferred. Specific examples thereof include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monomethyl ether, propylene glycol monoethyl ether, propylene glycol monomethyl ether acetate, propylene glycol propyl ether acetate, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxy cyclopentane, anisole, γ-butyrolactone, N-methylpyrrolidone, N,N-dimethylformamide, and N,N-dimethylacetamide. One of these solvents can be used alone, or two or more of these solvents can be used in combination.

Among these solvents, propylene glycol monomethyl ether, propylene glycol monomethyl ether acetate, ethyl lactate, butyl lactate, and cyclohexanone are preferred. In particular, propylene glycol monomethyl ether and propylene glycol monomethyl ether acetate are preferred.

The solvent preferably does not contain water. In other words, it is preferred that the organic film-forming composition does not contain water.

The content of water in the organic film-forming composition is not particularly limited, but is preferably 0 mass% to 10 mass%, more preferably 0 mass% to 5 mass%, and particularly preferably 0 mass% to 3 mass%.

The content of the solvent in the organic film-forming composition is not particularly limited, but is preferably 80 mass% to 99.99 mass%, more preferably 85 mass% to 99.9 mass%, and particularly preferably 90 mass% to 99 mass%.

In other words, the content of the organic film constituent component in the organic film-forming composition is not particularly limited, but is preferably 0.01 mass% to 20 mass%, more preferably 0.1 mass% to 15 mass%, and particularly preferably 1 mass% to 10 mass%.

### (Method for producing semiconductor element)

In an example, a method for producing a semiconductor element of the present invention includes an irradiation step, a resist pattern forming step, an organic film forming step, and an organic film removing step.

In an example, the method for producing a semiconductor element may include another step.

### <Irradiation step>

The irradiation step is a step of irradiating the metal-containing resist film with light or an electron beam.

The metal-containing resist film is not particularly limited, and preferably has at least one element of Si, Ge, Sn, Ti, Zr, Hf, Al, and Co.

The metal-containing resist film is formed of, for example, a metal-containing resist.

The metal-containing resist is also called a metal oxide resist (MOR), and typical examples thereof include a tin oxide-based resist.

The material of the metal oxide resist is, for example, a coating composition containing a metal oxo-hydroxo network having an organic ligand through a metal carbon bond and/or a metal carboxylate bond described in JP 2019-113855 A.

In an example of the metal-containing resist, a peroxo ligand is used as a radiation-sensitive stabilizing ligand. Details of the peroxo based metal oxo-hydroxo compounds are described, for example, in paragraph [0011] of JP 2019-532489 A: Patent Literature. Examples of the Patent Literature include US 9,176,377 B2, US 2013/0224652 A1, US 9,310,684 B2, US 2016/0116839 A1, and US 15/291738 A.

Other examples of the metal-containing resist include compositions described in JP 2011-253185 A, WO 2015/026482 A, WO 2016/065120 A, WO 2017/066319 A, WO 2017/156388 A, WO 2018/031896 A, JP 2020-122959 A, JP 2020-122960 A, WO 2019/099981 A, WO 2019/199467 A, WO 2019/195522 A, WO 2019/195522 A, WO 2020/210660 A, WO 2021/011367 A, and WO 2021/016229 A.

These contents are incorporated herein to the same extent as all the contents are specified.

The method for forming the metal-containing resist film from the metal-containing resist is not particularly limited, and examples thereof include a method in which a coating-type resist material (metal-containing resist film-forming composition) as the metal-containing resist is applied and fired.

The metal-containing resist film may be formed by vapor deposition. The method for forming the metal-containing resist film by vapor deposition is, for example, a method described in JP 2017-116923 A. The contents of JP 2017-116923 A are incorporated herein to the same extent as all the contents are specified. In JP 2017-116923 A, the metal-containing resist film in the present invention is referred to as a metal oxide-containing film.

The film thickness of the metal-containing resist film is, for example, 5 nm to 10,000 nm, or 5 nm to 1,000 nm, or 5 nm to 40 nm.

The metal-containing resist film is formed on, for example, a substrate, a resist underlayer film, or the like.

Examples of the substrate include a substrate used for producing a precision integrated circuit element. Examples of such a substrate include a semiconductor substrate such as a silicon wafer coated with a silicon oxide film, a silicon nitride film, or a silicon oxynitride film, a silicon nitride substrate, a quartz substrate, a glass substrate (alkali-free glass, low alkali glass, and crystallized glass are included.), a glass substrate on which an indium tin oxide (ITO) film or an indium zinc oxide (IZO) film is formed, a plastic (such as polyimide or PET) substrate, a low-dielectric constant material (low-k material) coated substrate, and a flexible substrate.

The resist underlayer film is not particularly limited, and for example, a known resist underlayer film can be used. Examples of the resist underlayer film include an organic underlayer film and a silicon-containing resist underlayer film.

The resist film may be formed directly on the substrate, or may be formed on the resist underlayer film of the substrate on which the resist underlayer film is formed. The resist underlayer film may be a single layer or a multilayer. For example, a two-layer resist underlayer film may be present between the substrate and the resist film. Examples of the two-layer resist underlayer film include a two-layer resist underlayer film of an organic underlayer film and a silicon-containing resist underlayer film.

The resist underlayer film has a film thickness of, for example, 10 nm to 1,000 nm, or 20 nm to 500 nm, or 50 nm to 300 nm, or 100 nm to 200 nm, or 10 to 150 nm.

Examples of the light or electron beam with which the metal-containing resist film is irradiated include a KrF excimer laser (wavelength: 248 nm), an ArF excimer laser (wavelength: 193 nm), an F₂ excimer laser (wavelength: 157 nm), EUV (wavelength: 13.5 nm), and an electron beam.

The irradiation amount of the light or electron beam with which the metal-containing resist film is irradiated is not particularly limited.

After the irradiation, post exposure bake can be performed as necessary. The post exposure bake is performed under conditions appropriately selected from, for example, a heating temperature of 70°C to 250°C and a heating time of 0.3 minutes to 10 minutes.

### <Resist pattern forming step>

The resist pattern forming step is a step of bringing a developer into contact with the metal-containing resist film irradiated with light or an electron beam to obtain a resist pattern.

An organic solvent can be used as the developer, and development is performed with the developer (solvent) after irradiation with light or an electron beam. As a result, for example, when a metal-containing negative resist film is used, the metal-containing resist film in an unexposed portion is removed, and a pattern of the metal-containing resist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3 methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3 ethoxypropionate, and propyl-3-methoxypropionate. Furthermore, a surfactant or the like may be added to these developers. Development conditions are appropriately selected from a temperature of 5°C to 50°C, and a time of 10 seconds to 600 seconds.

Examples of the development method using the developer include spin development by spin coating. The rotation speed at the time of spin development is not particularly limited, and is, for example, 500 rpm (rotations per minute) to 1,500 rpm. The time for spin development is not particularly limited, and is, for example, 30 seconds to 120 seconds.

In the resist pattern forming step, development is performed so that the resist pattern in contact with the developer is not dried.

Generally, in the formation of a resist pattern, drying is performed to remove the developer after development, but in the present invention, the developer is not dried. This is because when the developer is dried, a resist pattern collapse occurs.

For example, in a case where development is performed by spin development, spin drying is generally performed after spin development, but spin drying is not performed in the present invention. After the spin development, an organic film forming step is performed without performing spin drying.

In general, the rotation speed during spin drying is not particularly limited, and is, for example, 2,000 rpm to 3,000 rpm. The time for spin drying is not particularly limited, and is, for example, 10 seconds to 90 seconds.

### <Organic film forming step>

The organic film forming step is a step of applying the organic film-forming composition of the present invention on a resist pattern without drying the resist pattern with which the developer is in contact to form an organic film between the resist patterns.

The method for forming an organic film is not particularly limited, and examples thereof include spin coating. The rotation speed at the time of spin coating is not particularly limited, and is, for example, 500 rpm to 1,500 rpm. The time for spin coating is not particularly limited, and is, for example, 30 seconds to 120 seconds.

The organic film formed by the organic film forming step may be formed only between the resist patterns. The organic film may be formed on the resist pattern in addition to between the resist patterns.

The film thickness of the organic film to be formed is not particularly limited, and is set to, for example, an appropriate film thickness according to the film thickness of the metal-containing resist film. The film thickness of the organic film is, for example, in the range of 0.5 to 1.5 times the film thickness of the metal-containing resist film.

### <Organic film removing step>

The organic film removing step is not particularly limited as long as the organic film can be removed.

Examples of the method for removing the organic film include dry etching, wet etching (for example, decomposition removal with an acidic liquid), radiation etching, high-temperature firing, dissolution removal using a solvent, and an ozone treatment. One of these can be performed alone, or two or more of these can be performed in combination.

The temperature in high-temperature firing is, for example, 200°C to 300°C. The firing time in high-temperature firing is, for example, 1 minute or more. Examples of the atmosphere in high-temperature firing include an air atmosphere.

Examples of the solvent used for dissolution removal using a solvent include the organic solvents mentioned in the description of the developer (organic solvent) used in the resist pattern forming step described above.

Examples of a gas used in dry etching include tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride, chlorine trifluoride, chlorine, trichloroborane, and dichloroborane. One of these can be used alone, or two or more of these can be used in combination.

Radiation etching is performed, for example, by irradiation with an ultraviolet ray in the presence of oxygen (for example, under the atmosphere) or in the presence of an inert gas (for example, nitrogen).

In the radiation etching, the organic film is decomposed and removed by the ultraviolet ray.

Alternatively, in radiation etching, ozone is generated by irradiation with an ultraviolet ray (for example, an ultraviolet ray of 100 nm to 400 nm and 185 nm). Furthermore, when an ultraviolet ray (for example, 254 nm) is absorbed by ozone, active oxygen is generated. Then, the organic film is decomposed by the active oxygen. As a result, the organic film is removed.

In the organic film removing step, the organic film is preferably selectively removed. In this regard, the etching rate (etch rate) of the organic film when the organic film is removed is preferably 2 times or more, more preferably 10 times or more, and particularly preferably 20 times or more the etching rate of the metal-containing resist film. The upper limit of the etching rate is not particularly limited, but for example, the etching rate of the organic film when the organic film is removed is 100 times or less the etching rate of the metal-containing resist film.

In an example of the method for producing a semiconductor element, the resist underlayer film (intermediate layer) is removed using the resist pattern of the metal-containing resist film (upper layer) formed in this manner as a protective film, and then the organic underlayer film (lower layer) is removed using a film including the patterned metal-containing resist film and the patterned resist underlayer film (intermediate layer) as a protective film. Finally, the substrate is processed using the patterned resist underlayer film (intermediate layer) and the patterned organic underlayer film (lower layer) as protective films.

Removal (patterning) of the resist underlayer film (intermediate layer) performed using the pattern of the metal-containing resist film (upper layer) as the protective film is performed by dry etching, and a gas such as tetrafluoromethane (CF₄), perfluorocyclobutane (C₄F₈), perfluoropropane (C₃F₈), trifluoromethane, carbon monoxide, argon, oxygen, nitrogen, sulfur hexafluoride, difluoromethane, nitrogen trifluoride, chlorine trifluoride, chlorine, trichloroborane, or dichloroborane can be used.

A halogen-based gas is preferably used for dry etching of the resist underlayer film. In dry etching using a halogen-based gas, it is basically difficult to remove the metal-containing resist film. On the other hand, the resist underlayer film rich in silicon atoms is quickly removed with a halogen-based gas. Therefore, a decrease in the film thickness of the metal-containing resist film due to dry etching of the resist underlayer film can be prevented. As a result, the metal-containing resist film can be used as a thin film. Therefore, the dry etching of the resist underlayer film is preferably performed with a fluorine-based gas, and examples of the fluorine-based gas include tetrafluoromethane (CF₄), perfluorocyclobutane (C₄F₈), perfluoropropane (C₃F₈), trifluoromethane, and difluoromethane (CH₂F₂), but are not limited thereto.

When the organic underlayer film is provided between the substrate and the resist underlayer film, the organic underlayer film (lower layer) is preferably removed (patterned) by dry etching with an oxygen-based gas (oxygen gas, oxygen/carbonyl sulfide (COS) mixed gas, or the like), which is subsequently performed using a film including the patterned resist underlayer film (intermediate layer) as a protective film (together with the patterned metal-containing resist film (upper layer) when it remains). This is because it is difficult to remove the resist underlayer film of the present invention rich in silicon atoms by dry etching with an oxygen-based gas.

Thereafter, the processing (patterning) of the (semiconductor) substrate performed using the patterned resist underlayer film (intermediate layer) and, if desired, the patterned organic underlayer film (lower layer) as protective films is preferably performed by dry etching with a fluorine-based gas.

Examples of the fluorine-based gas include tetrafluoromethane (CF₄), perfluorocyclobutane (C₄F₈), perfluoropropane (C₃F₈), trifluoromethane, and difluoromethane (CH₂F₂).

After the removal (patterning) of the organic underlayer film or after the processing (patterning) of the substrate, the resist underlayer film may be removed. The resist underlayer film may be removed by dry etching or wet etching (wet method).

The dry etching of the resist underlayer film is preferably performed with a fluorine-based gas as mentioned in the patterning, and examples thereof include tetrafluoromethane (CF₄), perfluorocyclobutane (C₄F₈), perfluoropropane (C₃F₈), trifluoromethane, and difluoromethane (CH₂F₂), but are not limited thereto.

Examples of a chemical liquid used for wet etching of the resist underlayer film include alkaline solutions such as dilute fluorinated acid (hydrofluoric acid), buffered fluorinated acid (mixed solution of HF and NH₄F), an aqueous solution containing hydrochloric acid and hydrogen peroxide (SC-2 chemical liquid), an aqueous solution containing sulfuric acid and hydrogen peroxide (SPM chemical liquid), an aqueous solution containing fluorinated acid and hydrogen peroxide (FPM chemical liquid), and an aqueous solution containing ammonia and hydrogen peroxide (SC-1 chemical liquid). Examples of the alkaline solution include, in addition to the ammonia hydrogen peroxide obtained by mixing ammonia, aqueous hydrogen peroxide, and water (SC-1 chemical liquid), an aqueous solution containing 1 to 99 mass% of ammonia, tetramethylammonium hydroxide (TMAH), tetraethylammonium hydroxide, tetrapropylammonium hydroxide, tetrabutylammonium hydroxide, choline hydroxide, benzyltrimethylammonium hydroxide, benzyltriethylammonium hydroxide, DBU (diazabicycloundecene), DBN (diazabicyclononene), hydroxylamine, 1-butyl-1-methylpyrrolidinium hydroxide, 1-propyl-1-methylpyrrolidinium hydroxide, 1-butyl-1-methylpiperidinium hydroxide, 1-propyl-1-methylpiperidinium hydroxide, mepiquat hydroxide, trimethylsulfonium hydroxide, a hydrazine, an ethylenediamine, or guanidine. These chemical liquids can also be used in admixture.

An organic antireflection film can be formed on the resist underlayer film before the metal-containing resist film is formed. The antireflection film composition to be used is not particularly limited, and can be arbitrarily selected and used, for example, from those conventionally used in a lithography process, and the antireflection film can be formed by a commonly used method, for example, coating using a spinner or a coater and firing.

In addition, the substrate to which the silicon-containing resist underlayer film-forming composition for forming a silicon-containing resist underlayer film is applied may have an organic or inorganic antireflection film formed by a CVD method or the like on the surface thereof, and the resist underlayer film can be formed thereon. When the organic underlayer film is formed on the substrate and then the silicon-containing resist underlayer film is formed thereon, the substrate to be used may have an organic or inorganic antireflection film formed by a CVD method or the like on the surface thereof.

The resist underlayer film formed from the silicon-containing resist underlayer film-forming composition may also absorb light depending on the wavelength of the light used in a lithography process. In such a case, the resist underlayer film can function as an antireflection film having the effect of preventing reflection of light from the substrate.

Furthermore, the resist underlayer film can also be used as a layer for preventing interaction between the substrate and the metal-containing resist film, a layer having a function of preventing an adverse effect, on the substrate, of a material used for the metal-containing resist film or a substance generated at the time of exposure to the metal-containing resist film, a layer having a function of preventing diffusion of a substance generated from the substrate to the metal-containing resist film at the time of heating and firing, a barrier layer for reducing the poisoning effect of the metal-containing resist film by the semiconductor substrate dielectric layer, or the like.

### <Another Embodiment>

In another example of the method for producing a semiconductor element of the present invention, the organic film-forming composition may also serve as a developer. In that case, in another example, the method for producing a semiconductor element includes an irradiation step, a resist pattern and organic film forming step, and an organic film removing step.

Examples of the irradiation step include the above-described irradiation step.

Examples of the organic film removing step include the organic film removing step described above.

The resist pattern and organic film forming step is a step in place of the resist pattern forming step and the organic film forming step described above.

In the resist pattern and organic film forming step, the organic film-forming composition of the present invention is applied onto a metal-containing resist film irradiated with light or an electron beam, and the metal-containing resist film is developed to obtain a resist pattern, and also form an organic film between the resist patterns.

Therefore, in this example, the developer is not used.

The organic film-forming composition contains, for example, a solvent capable of dissolving an unexposed metal-containing resist film.

The application of the organic film-forming composition is performed by, for example, spin coating. The rotation speed at the time of spin coating is not particularly limited, and is, for example, 500 rpm to 1,500 rpm. The time for spin coating is not particularly limited, and is, for example, 30 seconds to 120 seconds.

### (Substrate with metal-containing resist pattern and method for producing substrate with metal-containing resist pattern)

The substrate with a metal-containing resist pattern of the present invention is a substrate with a metal-containing resist pattern in which an organic film is embedded between metal-containing resist patterns by applying the organic film-forming composition of the present invention onto a metal-containing resist pattern.

The method for producing a substrate with a metal-containing resist pattern of the present invention includes a step of applying the organic film-forming composition of the present invention onto a metal-containing resist pattern and embedding an organic film between the metal-containing resist patterns.

The metal-containing resist pattern is a resist pattern formed from a metal-containing resist film.

The metal-containing resist pattern can be formed, for example, by <Irradiation step> and <Resist pattern forming step> described above.

Examples of the method for forming an organic film include the application method mentioned in <Organic film forming step> described above.

The metal-containing resist pattern is formed on, for example, a substrate, a resist underlayer film, or the like.

Hereinafter, an embodiment of a method for producing a semiconductor element will be described with reference to the drawings.

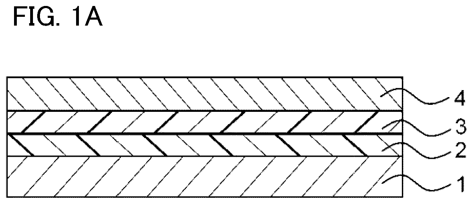

Figs. 1A to 1E are schematic cross-sectional views for explaining an embodiment of the method for producing a semiconductor element. In this embodiment, an irradiation step, a resist pattern forming step, an organic film forming step, and an organic film removing step are included.

First, a substrate 1 is prepared (Fig. 1A). On the substrate 1, an organic underlayer film 2, a silicon-containing resist underlayer film 3, and a metal-containing resist film 4 are laminated in this order.

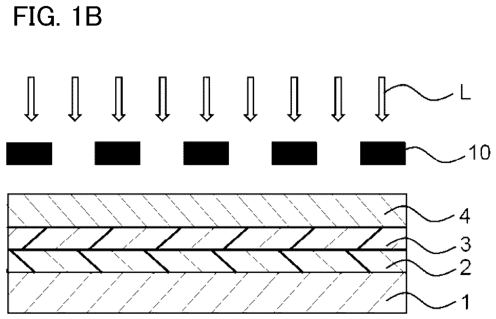

Subsequently, the metal-containing resist film 4 is irradiated with light L through a mask 10 (Fig. 1B). The light L is, for example, EUV light. In addition, the irradiation may be performed with an electron beam instead of the light L.

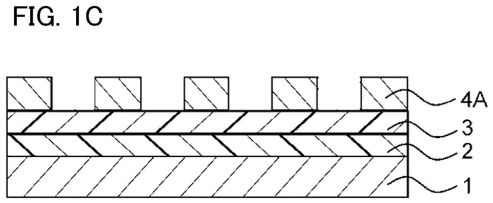

Subsequently, a developer is brought into contact with the metal-containing resist film irradiated with the light L to obtain a resist pattern 4A (Fig. 1C). Development is performed by spin development. At this time, spin drying is not performed.

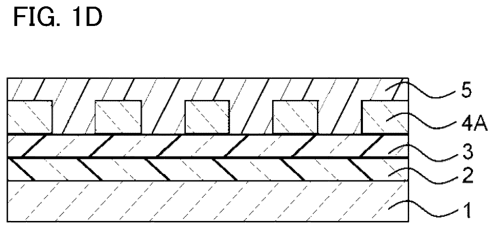

Subsequently, without performing spin drying, the organic film-forming composition of the present invention is applied onto the resist pattern 4A to form an organic film 5 between the resist patterns 4A (Fig. 1D). As illustrated in Fig. 1D, the organic film 5 may also be formed on the resist pattern 4A.

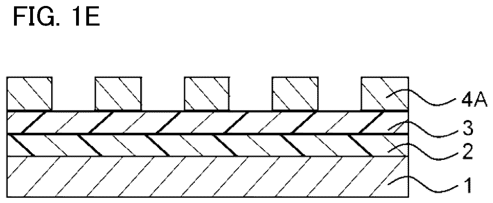

Subsequently, the organic film 5 is removed by etching (Fig. 1E).

This can provide a resist pattern in which pattern collapse is prevented.

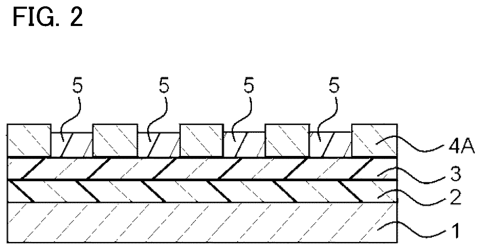

As illustrated in Fig. 2, the organic film 5 between the resist patterns 4A may exist only between the resist patterns 4A, and may not exist on the resist pattern 4A.

Hereinafter, another embodiment of a method for producing a semiconductor element will be described with reference to the drawings.

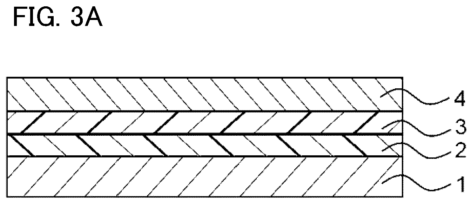

Figs. 3A to 3D are schematic cross-sectional views for explaining an embodiment of the method for producing a semiconductor element. In this embodiment, an irradiation step, a resist pattern and organic film forming step, and an organic film removing step are included. The organic film-forming composition also serves as a developer.

First, a substrate 1 is prepared (Fig. 3A). On the substrate 1, an organic underlayer film 2, a silicon-containing resist underlayer film 3, and a metal-containing resist film 4 are laminated in this order.

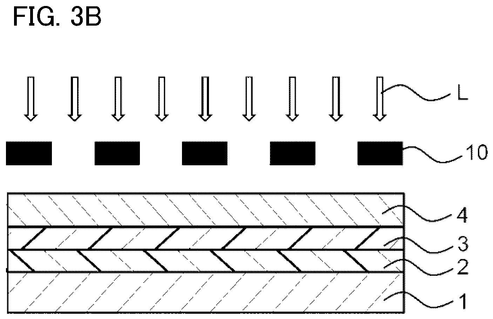

Subsequently, the metal-containing resist film 4 is irradiated with light L through a mask 10 (Fig. 3B). The light L is, for example, EUV light. In addition, the irradiation may be performed with an electron beam instead of the light L.

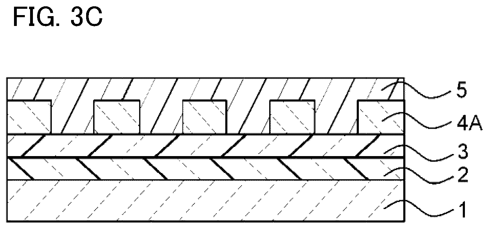

Subsequently, the organic film-forming composition of the present invention is applied onto the metal-containing resist film 4 irradiated with the light L, and the metal-containing resist film 4 is developed to obtain a resist pattern 4A, and also form an organic film 5 between the resist patterns 4A (Fig. 3C). Application is performed by spin coating.

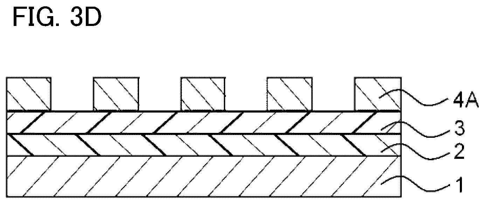

Subsequently, the organic film 5 is removed by etching (Fig. 3D).

This can provide a resist pattern in which pattern collapse is prevented.

### Examples

Hereinafter, the present invention will be described more specifically with reference to Synthesis Examples and Examples, but the present invention is not limited to only the following Examples.

In the Examples, apparatuses and conditions used for analysis of the physical properties of samples are as follows.

### (1) Measurement of molecular weight

The molecular weight used in the present invention is a molecular weight obtained in terms of polystyrene by GPC analysis. Measurement conditions of GPC are as follows.
· GPC apparatus: trade name HLC-8220GPC (manufactured by TOSOH CORPORATION)
· GPC column: trade name Shodex (registered trademark) KF803L, KF802, KF801 (manufactured by Showa Denko K.K.)
· Column temperature: 40°C
· Eluent (elution solvent): tetrahydrofuran
· Flow rate: 1.0 mL/min
· Standard sample: polystyrene (manufactured by Showa Denko K.K.)

### [1] Synthesis of polymer

### (Synthesis Example 1)

In a two-necked flask, 40.0 g of EHPE 3150 (trade name) (manufactured by Daicel Chemical Industries, Ltd.), 20.3 g of 9-anthracene carboxylic acid, and 13.7 g of benzoic acid were dissolved in 302.0 g of propylene glycol monomethyl ether, and then 1.5 g of benzyltriethylammonium was added thereto and a reaction was allowed to proceed under reflux for 24 hours. To the obtained solution, 11 g of an anion exchange resin and 11 g of a cation exchange resin were added, and an ion exchange treatment was performed at room temperature for 4 hours. The ion exchange resin was separated to obtain a solution of a polymer of formula (E-1). The obtained resin had a weight average molecular weight Mw as measured by GPC in terms of polystyrene of 4,100.

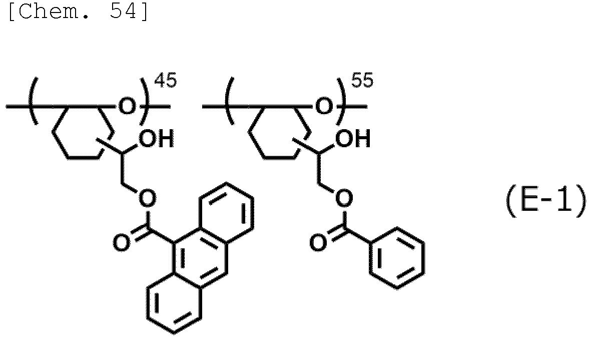

### (Synthesis Example 2)

In 64.4 g of tetrahydrofuran in a flask, 6.6 g (0.039 mol) of butyrolactone methacrylate, 6.6 g (0.046 mol) of 2-hydroxypropyl methacrylate, and 6.8 g (0.039 mol) of benzyl methacrylate were dissolved, and then the inside of the flask was replaced with nitrogen, and the temperature was raised to reflux temperature. After the start of reflux, 0.2 g of azobisisobutyronitrile (AIBN) dissolved in 10 g of tetrahydrofuran was added thereto under nitrogen pressure, and a reaction was allowed to proceed for 24 hours. The reaction solution was cooled and then added to diethyl ether, and the polymer was reprecipitated and dried by heating to obtain a polymer of formula (E-2). The obtained polymer had a polymerization degree of 490, a weight average molecular weight Mw of 80,000 (in terms of polystyrene), and a yield of 90%.

In 48.5 g of propylene glycol monomethyl ether, 1.5 g of the obtained polymer was dissolved to obtain a polymer solution.

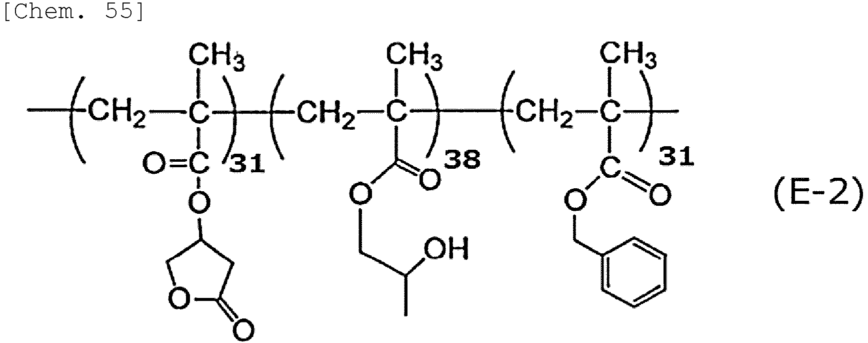

### (Synthesis Example 3)

In 682 g of propylene glycol monomethyl ether, 100 g of monoallyl diglycidyl isocyanurate (manufactured by Shikoku Chemicals Corporation), 66.4 g of 5,5-diethylbarbituric acid, and 4.1 g of benzyltriethylammonium chloride were dissolved, and then a reaction was allowed to proceed at 130°C for 24 hours to obtain a solution containing a polymer having a structure of formula (E-3) as a repeating unit structure. As a result of GPC analysis, the obtained polymer had a weight average molecular weight of 6,800 in terms of standard polystyrene.

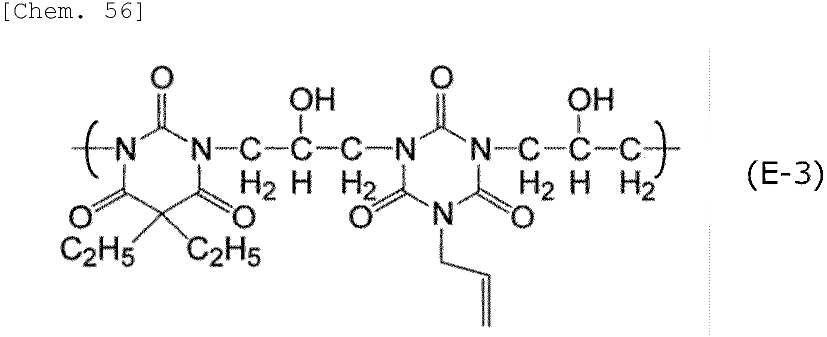

### (Synthesis Example 4)

Into a reaction container equipped with a thermometer, a cooling tube, a dropping device, and a stirring device, 30.00 g of propylene glycol monomethyl ether acetate was charged, and the temperature was raised to 80°C under a nitrogen atmosphere. In another container, 15.46 g of methyl methacrylate (product of Tokyo Chemical Industry Co., Ltd.) and 2.53 g of dimethyl azobis(isobutyrate) (product of Fujifilm Wako Pure Chemical Industries, Ltd.) were dissolved in 42.00 g of propylene glycol monomethyl ether acetate, and the resulting solution was charged into a dropping container, and added dropwise to the reaction container over 30 minutes under a nitrogen atmosphere.

The resulting mixture was stirred at 80°C for 24 hours under a nitrogen atmosphere to obtain a solution containing a polymer of methyl methacrylate. As a result of GPC analysis, the obtained polymer had a weight average molecular weight Mw of 6,300. The obtained polymer can be represented by formula (E-4) below.

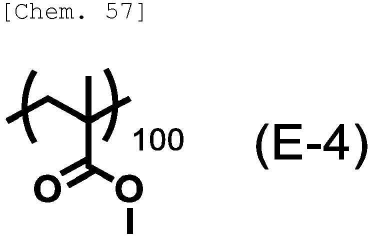

### [2-1] Measurement of O₂ etching rate

The following etchers and etching gas were used for the measurement of the O₂ etching rate.
Etcher: RIE-10NR (manufactured by SAMCO Inc.)
Etching gas: O₂ gas

Each of the polymer solutions obtained in Synthesis Examples 1 to 4 was applied onto a silicon wafer using a spinner. Heating was performed on a hot plate at 250°C for 1 minute to form a coating film having a film thickness of 50 nm.

Similarly, a tin oxide-based resist composition was formed into a resist film (film thickness: 22 nm) on a silicon wafer using a spinner.

With respect to each of the coating film obtained from the polymer solution and the resist film obtained from the tin oxide-based resist composition, a dry etching rate was measured using O₂ gas as an etching gas. The dry etching rate of the coating film prepared from each of the polymer solutions obtained in Synthesis Examples 1 to 4 was compared with the dry etching rate of the resist film obtained from the tin oxide-based resist composition.

The obtained results are shown in Table 1. The etch rate in Table 1 is an etch rate when the etch rate of the resist film obtained from the tin oxide-based resist composition was taken as 1.

**[Table 1]**

| | Oxygen-based gas etch rate (relative to tin oxide-based resist) |
|---|---|
| Synthesis Example 1 | 27.6 |
| Synthesis Example 2 | 58.3 |
| Synthesis Example 3 | 46.8 |
| Synthesis Example 4 | 62.4 |

### [2-2] Measurement of UV/O₃ etching rate

The following etcher was used for measuring the UV/O₃ etching rate.
Etcher: SUS867 (manufactured by USHIO INC.)

Each of the polymer solutions obtained in Synthesis Examples 1 to 4 was applied onto a silicon wafer using a spinner. Heating was performed on a hot plate at 250°C for 1 minute to form a coating film having a film thickness of 50 nm.

Similarly, a tin oxide-based resist composition was formed into a resist film (film thickness: 22 nm) on a silicon wafer using a spinner.

Each of the coating film obtained from the polymer solution and the resist film obtained from the tin oxide-based resist composition was irradiated with light of 172 nm in the presence of air to measure the UV/O₃ etching rate. The dry etching rate of the coating film prepared from each of the polymer solutions obtained in Synthesis Examples 1 to 4 was compared with the dry etching rate of the resist film obtained from the tin oxide-based resist composition.

The obtained results are shown in Table 2. The etch rate in Table 2 is an etch rate when the etch rate of the resist film obtained from the tin oxide-based resist composition was taken as 1.

**[Table 2]**

| | UV/O₃ etching rate (relative to tin oxide-based resist) |
|---|---|
| Synthesis Example 1 | 3.8 |
| Synthesis Example 2 | 32.7 |
| Synthesis Example 3 | 5.0 |
| Synthesis Example 4 | 40.2 |

### [3] Preparation of organic underlayer film-forming composition

Under nitrogen, carbazole (6.69 g), 9-fluorenone (7.28 g), and p-toluenesulfonic acid monohydrate (0.76 g) were added in a 100 ml four-necked flask, and 1,4-dioxane (6.69 g) was charged and the mixture was stirred and heated to 100°C for dissolution, and polymerization was initiated. After 24 hours, the mixture was allowed to cool to 60°C.

The cooled reaction mixture was diluted by adding chloroform (34 g) thereto, and the diluted mixture was added to methanol (168 g) for precipitation. The obtained precipitate was recovered by filtration, and the recovered solid was dried with a vacuum dryer at 80°C for 24 hours to obtain 9.37 g of a desired polymer represented by formula (T) (hereinafter abbreviated as PCzFL).

PCzFL was found to have a weight average molecular weight Mw of 2,800 as determined by GPC in terms of polystyrene and a polydispersity Mw/Mn of 1.77.

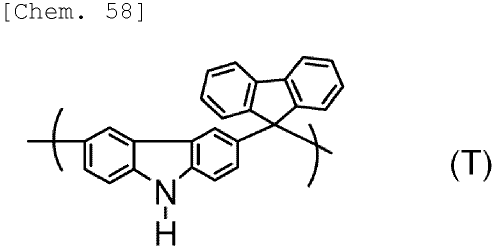

PCzFL (20 g), 3.0 g of tetramethoxymethyl glycoluril (Powder Link 1174 (trade name), manufactured by Nippon Cytec Industries (former Mitsui Cytec Ltd.)) as a crosslinking agent, 0.30 g of pyridinium p-toluenesulfonate as a catalyst, and 0.06 g of MEGAFACE R-30 (manufactured by DIC Corporation, trade name) as a surfactant were mixed, and the resulting mixture was dissolved in 88 g of propylene glycol monomethyl ether acetate to prepare a solution. Thereafter, the obtained solution was filtered using a polyethylene microfilter having a pore size of 0.10 µm, and further filtered using a polyethylene microfilter having a pore size of 0.05 µm to prepare an organic underlayer film-forming composition.

### [4] Preparation of resist underlayer film-forming composition

In a 300 ml flask, 20.8 g of tetraethoxysilane, 7.6 g of methyltriethoxysilane, and 62.1 g of propylene glycol monoethyl ether were placed, and 8.4 g of a 0.2 M nitric acid aqueous solution was added dropwise thereto while the resulting mixed solution was stirred with a magnetic stirrer.

After the dropwise addition, the flask was transferred to an oil bath set at 60°C and the mixed solution was refluxed for 20 hours. Thereafter, ethanol and water as reaction by-products were distilled off under reduced pressure and the residue was concentrated to obtain a hydrolysis condensate (polymer) aqueous solution.

Further, propylene glycol monoethyl ether was added to the solution to achieve a solvent proportion of propylene glycol monoethyl ether of 100% and a concentration of 10 mass% in terms of solid residue at 150°C, and filtration was performed with a nylon filter (pore size: 0.1 µm). The obtained polysiloxane polymer had a structure represented by formula (U) below and had a weight average molecular weight Mw of 2,400 as determined by GPC in terms of polystyrene.

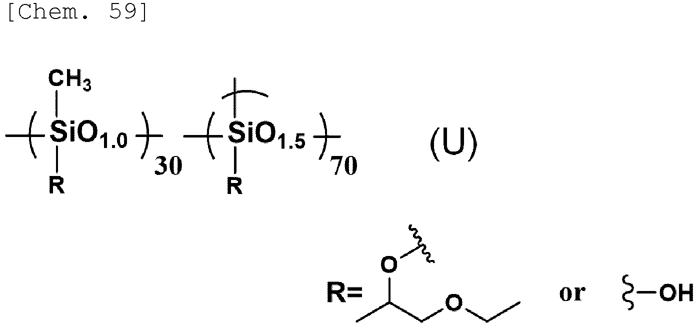

The obtained polysiloxane polymer solution (solid content: 10 mass%) (4.9 g), maleic acid (0.005 g), triphenylsulfonium nitrate (0.005 g), and propylene glycol monoethyl ether (195 g) were mixed, and the mixture was filtered through a fluororesin filter having a pore size of 0.1 µm to prepare a resist underlayer film-forming composition.

### [5-1] Example 1

### <Formation of resist pattern>

The organic underlayer film-forming composition was applied onto a silicon wafer by spin coating, and heated on a hot plate at 215°C for 1 minute to form an organic underlayer film (layer A) (film thickness: 90 nm).

The resist underlayer film-forming composition was applied thereon by spin coating, and heated on a hot plate at 215°C for 1 minute to form a resist underlayer film (layer B) (film thickness: 10 nm).

Further, a resist solution (tin oxide-based resist) was applied thereon by spin coating, and heated at 130°C for 1 minute to form an EUV resist layer (layer C), and then exposed using an EB exposure apparatus (ELS-G130) manufactured by ELIONIX INC. At the time of exposure, exposure was performed so that the line width of the resist was 16 nm and the inter-line width (space width) was 28 nm after the following development.

After the exposure, the film was subjected to post exposure bake (PEB, 180°C for 1 min), cooled to room temperature on a cooling plate, and spin-developed at 1,000 rpm for 60 seconds using an organic solvent (propylene glycol monomethyl ether acetate) as the developer. Thereafter, the polymer solution prepared in Synthesis Example 1 was applied without performing spin drying, and propylene glycol monomethyl ether acetate used for development was replaced with this solution. Thereafter, the silicon substrate was spun at 1,500 rpm for 60 seconds to dry the solvent in the solution, and then heated at 250°C for 60 seconds to form a coating film, and the resist pattern was embedded. The formed coating film was removed by dry etching using a mixed gas of O₂ (flow rate: 10 sccm) and N₂ (flow rate: 20 sccm) to obtain a resist pattern.

### [5-2] Example 2

### <Formation of resist pattern>

A resist pattern was obtained in the same manner as in Example 1 except that the polymer solution prepared in Synthesis Example 1 in Example 1 was changed to the polymer solution prepared in Synthesis Example 2.

### [5-3] Example 3

### <Formation of resist pattern>

A resist pattern was obtained in the same manner as in Example 1 except that the polymer solution prepared in Synthesis Example 1 in Example 1 was changed to the polymer solution prepared in Synthesis Example 3.

### [5-4] Example 4

### <Formation of resist pattern>

A resist pattern was obtained in the same manner as in Example 1 except that the polymer solution prepared in Synthesis Example 1 in Example 1 was changed to the polymer solution prepared in Synthesis Example 4.

### [5-5] Example 5

### <Formation of resist pattern>

The organic underlayer film-forming composition was applied onto a silicon wafer by spin coating, and heated on a hot plate at 215°C for 1 minute to form an organic underlayer film (layer A) (film thickness: 90 nm).

The resist underlayer film-forming composition was applied thereon by spin coating, and heated on a hot plate at 215°C for 1 minute to form a resist underlayer film (layer B) (film thickness: 10 nm).

Further, a resist solution (tin oxide-based resist) was applied thereon by spin coating, and heated at 130°C for 1 minute to form an EUV resist layer (layer C), and then exposed using an EB exposure apparatus (ELS-G130) manufactured by ELIONIX INC. At the time of exposure, exposure was performed so that the line width of the resist was 16 nm and the inter-line width (space width) was 28 nm after the following development.

After the exposure, the film was subjected to post exposure bake (PEB, 180°C for 1 min), cooled to room temperature on a cooling plate, and spin-developed at 1,000 rpm for 60 seconds using an organic solvent (propylene glycol monomethyl ether acetate) as the developer. Thereafter, the polymer solution prepared in Synthesis Example 4 was applied without performing spin drying, and propylene glycol monomethyl ether acetate used for development was replaced with this solution. Thereafter, the silicon substrate was spun at 1,500 rpm for 60 seconds to dry the solvent in the solution, and then heated at 250°C for 60 seconds to form a coating film, and the resist pattern was embedded. The formed coating film was irradiated with light of 172 nm in the presence of air using SUS867 (manufactured by USHIO INC.), and removed by UV/O₃ etching for 120 seconds to obtain a resist pattern.

### [6] Comparative Example 1

### <Formation of resist pattern>

The organic underlayer film-forming composition was applied onto a silicon wafer by spin coating, and heated on a hot plate at 215°C for 1 minute to form an organic underlayer film (layer A) (film thickness: 90 nm).

The resist underlayer film-forming composition was applied thereon by spin coating, and heated on a hot plate at 215°C for 1 minute to form a resist underlayer film (layer B) (film thickness: 10 nm).

Further, a resist solution (tin oxide-based resist) was applied thereon by spin coating, and heated at 130°C for 1 minute to form an EUV resist layer (layer C), and then exposed using an EB exposure apparatus (ELS-G130) manufactured by ELIONIX INC. At the time of exposure, exposure was performed so that the line width of the resist was 16 nm and the inter-line width (space width) was 28 nm after the following development.

After the exposure, the film was subjected to post exposure bake (PEB, 180°C for 1 min), cooled to room temperature on a cooling plate, and spin-developed at 1,000 rpm for 60 seconds using an organic solvent (propylene glycol monomethyl ether acetate) as the developer. Thereafter, spin drying was performed at 2,500 rpm for 30 seconds to remove the developer to obtain a resist pattern.

With respect to the resist pattern obtained in each of Examples 1 to 4 and Comparative Example 1, the length of the pattern dimension was measured with a length measuring SEM (CG4100) manufactured by Hitachi High-Tech Corporation. The obtained results are shown in Table 3. In Table 3, "Good" means that a pattern having a dimension of 16 nm was formed without peeling or bending.

**[Table 3]**

| | Pattern shape |
|---|---|
| Example 1 | Good |
| Example 2 | Good |
| Example 3 | Good |
| Example 4 | Good |
| Example 5 | Good |
| Comparative Example 1 | Peeled |

As shown in Table 3, when a pattern is formed by embedding a pattern after development using a polymer solution and then removing a resin by dry etching, peeling of the pattern during development is prevented, and a fine pattern can be formed.

### Reference Signs List

- 1: Substrate
- 2: Organic underlayer film
- 3: Silicon-containing resist underlayer film
- 4: Metal-containing resist film
- 4A: Resist pattern
- 5: Organic film
- 10: Mask
- L: Light

## Claims

1. An organic film-forming composition, which is used for forming an organic film that is formed between resist patterns formed from a metal-containing resist film and that is then removed,
the organic film-forming composition comprising: an organic film constituent component; and a solvent.

2. The organic film-forming composition according to claim 1, wherein the metal-containing resist film has at least one element of Si, Ge, Sn, Ti, Zr, Hf, Al, and Co.

3. The organic film-forming composition according to claim 1, wherein the organic film constituent component contains a polymer (A).

4. The organic film-forming composition according to claim 3, wherein the polymer (A) is not water-soluble.

5. The organic film-forming composition according to claim 4, wherein the polymer (A) is a polymer (A1) having a ring structure.

6. The organic film-forming composition according to claim 5, wherein the polymer (A1) is a polymer (A1-1) having a ring structure in a main chain.

7. The organic film-forming composition according to claim 5, wherein the polymer (A1) is a polymer (A1-2) having a ring structure in a side chain.

8. The organic film-forming composition according to claim 6, wherein at least one type of ring structure of the main chain in the polymer (A1-1) is a monocyclic aliphatic ring.

9. The organic film-forming composition according to claim 8, wherein the polymer (A1-1) is a polymer (X) having a repeating unit represented by formula (X) below: 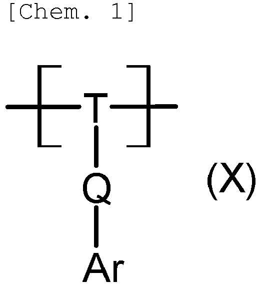
wherein T represents a group having a monocyclic aliphatic ring constituting a main chain of the polymer (X),
Q represents a divalent linking group, and
Ar represents an aromatic group which may have a substituent.

10. The organic film-forming composition according to claim 6, wherein at least one type of ring structure of the main chain in the polymer (A1-1) is a heterocycle.

11. The organic film-forming composition according to claim, wherein the polymer (A1-1) is a polymer (Y) having a repeating unit represented by formula (Y) below: 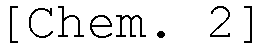 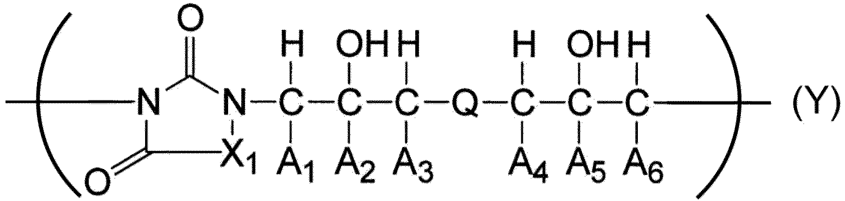
wherein A₁, A₂, A₃, A₄, A₅, and A₆ each represent a hydrogen atom, a methyl group, or an ethyl group,
X₁ represents formula (Y2), (Y3), (Y4), or (Y0) below,
Q represents formula (Y5) or (Y6) below, 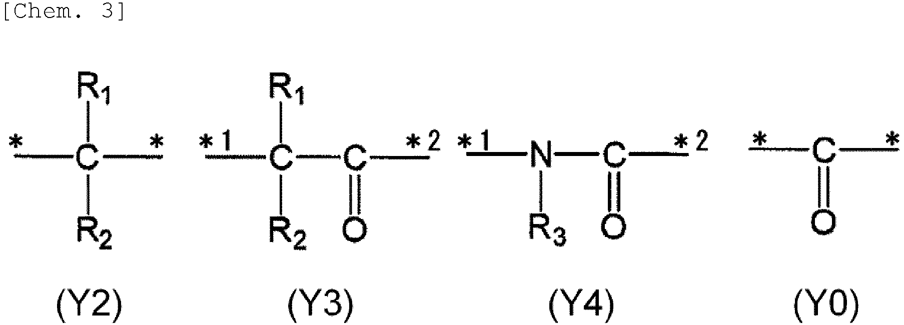
wherein R₁ and R₂ each represent a hydrogen atom, a halogen atom, an alkyl group having 1 to 6 carbon atoms, an alkenyl group having 3 to 6 carbon atoms, a benzyl group, or a phenyl group, and the alkyl group having 1 to 6 carbon atoms, the alkenyl group having 3 to 6 carbon atoms, the benzyl group, and the phenyl group may be substituted with a group selected from a group consisting of an alkyl group having 1 to 6 carbon atoms, a halogen atom, an alkoxy group having 1 to 6 carbon atoms, a nitro group, a cyano group, a hydroxy group, a carboxyl group, and an alkylthio group having 1 to 6 carbon atoms, R₁ and R₂ may be bonded to each other to form a ring having 3 to 6 carbon atoms,
R₃ represents a halogen atom, an alkyl group having 1 to 6 carbon atoms, an alkenyl group having 3 to 6 carbon atoms, a benzyl group, or a phenyl group, and the phenyl group may be substituted with a group selected from a group consisting of an alkyl group having 1 to 6 carbon atoms, a halogen atom, an alkoxy group having 1 to 6 carbon atoms, a nitro group, a cyano group, a hydroxy group, and an alkylthio group having 1 to 6 carbon atoms,
* represents a bond, *1 represents a bond bonded to a carbon atom, and *2 represents a bond bonded to a nitrogen atom, 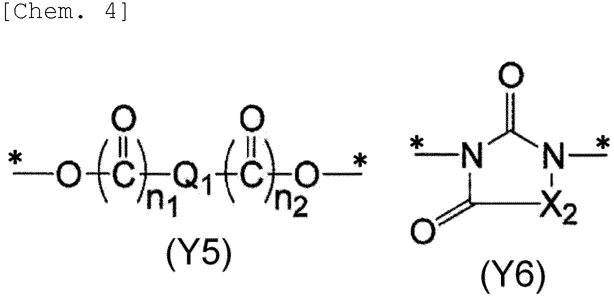
wherein Q₁ represents an alkylene group having 1 to 10 carbon atoms, a phenylene group, a naphthylene group, or an anthrylene group, and each of the alkylene group, the phenylene group, the naphthylene group, and the anthrylene group may be substituted with an alkyl group having 1 to 6 carbon atoms, a carbonyloxyalkyl group having 2 to 7 carbon atoms, a halogen atom, an alkoxy group having 1 to 6 carbon atoms, a phenyl group, a nitro group, a cyano group, a hydroxy group, an alkylthio group having 1 to 6 carbon atoms, a group having a disulfide group, a carboxyl group, or groups of a combination thereof,
n₁ and n₂ each represent 0 or 1,
X₂ represents the formula (Y2), (Y3), or (Y0), and
* represents a bond.

12. The organic film-forming composition according to claim 7, wherein at least one type of ring structure of the side chain in the polymer (A1-2) is a heterocycle.

13. The organic film-forming composition according to claim 7, wherein at least one type of ring structure of the side chain in the polymer (A1-2) is a lactone ring.

14. The organic film-forming composition according to claim 13, wherein the polymer (A1-2) is a polymer (Z) having a repeating unit represented by formula (Z) below: 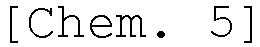 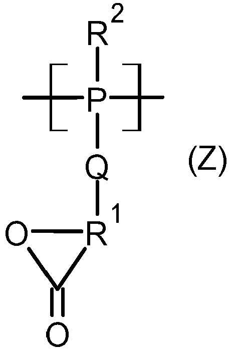
wherein Q represents a divalent linking group,
R¹ represents a substituted or unsubstituted trivalent hydrocarbon group having 3 or 4 carbon atoms,
P represents a bonding group constituting a main chain, and
R² represents a hydrogen atom, a methyl group, or a halogen atom.

15. The organic film-forming composition according to claim 4, wherein the polymer (A) is a polymer (A2) having a repeating unit represented by formula (Q) below: 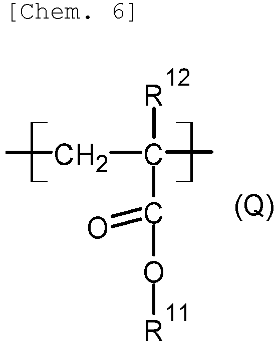
wherein R¹¹ represents an alkyl group having 1 to 4 carbon atoms, and
R¹² represents a hydrogen atom, a methyl group, or a halogen atom.

16. The organic film-forming composition according to claim 1, which is used for preventing the resist pattern from collapsing.

17. The organic film-forming composition according to claim 1, which also serves as a developer when the resist pattern is formed.

18. A method for producing a semiconductor element, the method comprising:
a step of irradiating a metal-containing resist film with light or an electron beam;
a step of bringing a developer into contact with the metal-containing resist film irradiated with light or an electron beam to obtain a resist pattern;
a step of applying the organic film-forming composition according to any one of claims 1 to 16 onto the resist pattern without drying the resist pattern with which the developer is in contact to form an organic film between the resist patterns; and
a step of removing the organic film.

19. The method for producing a semiconductor element according to claim 18, wherein in the step of forming the organic film, the organic film is also formed on the resist pattern.

20. The method for producing a semiconductor element according to claim 18, wherein the step of removing the organic film is selected from dry etching, wet etching, radiation etching, high-temperature firing, dissolution removal using a solvent, and an ozone treatment.

21. A substrate with a metal-containing resist pattern, wherein the organic film-forming composition according to any one of claims 1 to 16 is applied onto a metal-containing resist pattern so that an organic film is embedded between the metal-containing resist patterns.
